(19) Europäisches Patentamt
European Patent Office
Office européen des brevets

(11) **EP 2 515 344 A1**

(12) **EUROPEAN PATENT APPLICATION**
published in accordance with Art. 153(4) EPC

(43) Date of publication:
**24.10.2012 Bulletin 2012/43**

(51) Int Cl.:
**H01L 31/04** (2006.01)   **H01L 51/42** (2006.01)

(21) Application number: **10837486.9**

(22) Date of filing: **08.12.2010**

(86) International application number:
**PCT/JP2010/072019**

(87) International publication number:
**WO 2011/074457 (23.06.2011 Gazette 2011/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.12.2009 JP 2009283569**
**06.05.2010 JP 2010106523**

(71) Applicant: **Sony Corporation**
**Tokyo 108-0075 (JP)**

(72) Inventors:
• **YOSHIDA Hironori**
**Tokyo 108-0075 (JP)**
• **YATABE Toru**
**Tokyo 108-0075 (JP)**
• **ENOMOTO Masashi**
**Tokyo 108-0075 (JP)**
• **KAGEYAMA Masamitsu**
**Tokyo 108-0075 (JP)**

(74) Representative: **Horner, David Richard**
**D Young & Co LLP**
**120 Holborn**
**London EC1N 2DY (GB)**

(54) **PHOTOELECTRIC CONVERSION ELEMENT AND METHOD FOR MANUFACTURING PHOTOELECTRIC CONVERSION ELEMENT**

(57)     A photoelectric conversion device enabling an improvement in photoelectric conversion efficiency and a method of manufacturing the photoelectric conversion device are provided. A solar cell 1 includes a transparent substrate 22 having, on a surface, a three-dimensional structure 22A where a plurality of convex portions 22B are regularly arranged, and a light receiving element 23 being provided on the surface of the transparent substrate 22, and including a transparent electrode 24, a photoelectric conversion layer 25, and a reflective electrode 26 in this order of closeness to the transparent substrate 22. At least the transparent electrode 24 of the light receiving element 23 has a three-dimensional structure 24A in accordance with the three-dimensional structure 22A on a surface on a side opposite to the transparent substrate 22. The photoelectric conversion layer 25 effectively absorbs incident light, and allows an electric field to be concentrated, causing an increase in current density. Such an increase in current density is caused by a reduction in resistance of the element due to the concentration of an electric field. As a result, a generated current may be efficiently extracted.

[ FIG. 1 ]

**Description**

TECHNICAL FIELD

The present invention relates to a photoelectric conversion device suitable for a solar cell device including an organic compound, for example, and a method of manufacturing the photoelectric conversion device.

BACKGROUND ART

Recently, a solar cell has been put to practical use in various fields, as a power-generating unit enabling resource saving and cost reduction. While a solar cell including a silicon thin film has been the mainstream of such a solar cell, recently, there is a growing interest in inorganic compounds such as CdTe or CIGS compounds, and in organic compounds such as high and low molecular-weight polymers, as an alternative material to the silicon thin film. In addition, a dye-sensitized solar cell and the like are under development. In particular, a solar cell (an organic solar cell) including the organic compound such as a polymer is convenient for simplification of a manufacturing process and a reduction in cost, and therefore various research and development of the organic solar cell are being carried out for practical use (for example, see PTL 1).

The solar cell as described above typically has a structure where a transparent electrode, a photoelectric conversion layer, and a reflective electrode are provided in this order on a transparent substrate such as a glass substrate. In such a structure, light entering the photoelectric conversion layer through the transparent substrate is allowed to be extracted to the outside in the form of a photocurrent through the transparent electrode and the reflective electrode. In this way, the solar cell internally captures light energy such as sunlight, and converts the light energy to electric energy and thus generates power.

[Citation List]

[Patent Literature]

[PTL 1] Japanese Unexamined Patent Application Publication No. 2009-278145.

SUMMARY OF THE INVENTION

However, although the solar cell, particularly the organic solar cell including the organic compound is advantageous in productivity, the solar cell is limited in a wavelength range to be absorbed depending on a material to be used, and has a large device resistance, so that a generated current is not allowed to be efficiently extracted. This leads to a problem of extremely low photoelectric conversion efficiency. It is therefore desirable to improve the photoelectric conversion efficiency of the solar cell (photoelectric conversion device) such as the organic solar cell.

The invention is made in the light of such a problem, and an object of the invention is to provide a photoelectric conversion device enabling an improvement in photoelectric conversion efficiency, and a method of manufacturing the photoelectric conversion device.

A first photoelectric conversion device according to the invention includes: a substrate including, on a surface, a first three-dimensional structure where a plurality of convex portions are regularly arranged; and a light receiving element being provided on the surface of the substrate, and including a first electrode, a photoelectric conversion layer, and a second electrode in this order of closeness to the substrate. At least the first electrode of the light receiving element has a second three-dimensional structure in accordance with the first three-dimensional structure on a surface on a side opposite to the substrate.

A method of manufacturing a photoelectric conversion device according to the invention includes: forming, on a surface of a substrate, a first three-dimensional structure in which a plurality of convex portions are regularly arranged; and forming a light receiving element including a first electrode, a photoelectric conversion layer, and a second electrode in this order on the surface of the substrate on which the first three-dimensional structure is formed. The forming of the light receiving element includes forming a second three-dimensional structure in accordance with the first three-dimensional structure on at least a surface, on a side opposite to the substrate, of the first electrode. The first three-dimensional structure on the substrate is formed with a die including, for example, a predetermined concave-convex pattern.

The first photoelectric conversion device according to the invention has the first three-dimensional structure where the plurality of convex portions are regularly arranged on the surface of the substrate, wherein at least the first electrode of the light receiving element has the second three-dimensional structure in accordance with the first three-dimensional structure on the surface, on the side opposite to the substrate, of the first electrode. The photoelectric conversion layer effectively absorbs incident light, and allows an electric field to be concentrated, causing an increase in current density. Such an increase in current density is caused by a reduction in resistance of the device due to the concentration of an electric field. As a result, a generated current is allowed to be efficiently extracted.

In the method of manufacturing a photoelectric conversion device according to the invention, the plurality of convex portions are formed in a regularly arranged manner to form the first three-dimensional structure, on the surface of the substrate, and then the first electrode, the photoelectric conversion layer, and the second electrode are formed in this order on the surface of the substrate. The second three-dimensional structure in accordance with the first three-dimensional structure is provided on at least the surface, on the side opposite to the substrate, of the first electrode. The first three-dimensional structure on the substrate is formed with a die having a predetermined concave-convex pattern, for example, thereby facilitating formation of the first three-dimensional structure having a fine regularity of the order of nanometer, for example.

A second photoelectric conversion device according to the invention includes: a substrate including a first concave-convex structure, and a second concave-convex structure on a principal surface, the first concave-convex structure including a plurality of first convex portions, the second concave-convex structure being provided on a surface of the first concave-convex structure and including a plurality of second convex portions; and a light receiving element being provided on one principal surface side of the substrate, and including a first electrode, a photoelectric conversion layer, and a second electrode in this order of closeness to the substrate. At least the first electrode of the light receiving element includes a third concave-convex structure in accordance with one or both of the first and second concave-convex structures on a surface on a side opposite to the substrate.

According to the first photoelectric conversion device and the method of manufacturing the photoelectric conversion device according to the invention, the plurality of convex portions are regularly arranged on the surface of the substrate (the first three-dimensional structure), and at least the first electrode has the second three-dimensional structure in accordance with the first three-dimensional structure on the surface, on the side opposite to the substrate, of the first electrode, and thereby photoelectric conversion efficiency is allowed to be improved.

BRIEF DESCRIPTION OF THE DRAWINGS

[FIG.1] FIG. 1 includes a perspective view and a sectional view of a solar cell according to a first embodiment of the invention.
[FIG. 2] FIG. 2 includes sectional views illustrating a manufacturing process of a transparent substrate shown in FIG. 1.
[FIG. 3] FIG. 3 illustrates an exemplary apparatus that produces the transparent substrate in a roll-to-roll manner.
[FIG. 4] FIG. 4 illustrates an exemplary production of the transparent substrate with a plate-like master.
[FIG. 5] FIG. 5 is a conceptual view explaining intensity and a shape of a laser beam.
[FIG. 6] FIG. 6 includes diagrams illustrating laser optical systems for production of a roll-like master and of the plate-like master, respectively, by laser processing.
[FIG. 7] FIG. 7 includes relationship diagrams between a voltage and current density measured without light irradiation.
[FIG. 8] FIG. 8 is a relationship diagram between a voltage and current density measured with light irradiation.
[FIG. 9] FIG. 9 is a relationship diagram between incident wavelengths and light absorptance of a solar cell 1 as a whole.
[FIG. 10] FIG. 10 includes diagrams illustrating device structures (flat plate, a pitch of 150 nm) used for simulation.
[FIG. 11] FIG. 11 includes diagrams illustrating actual measurement results of impedance.
[FIG. 12] FIG. 12 is a characteristic diagram illustrating a relationship between a pitch and a resistance value (measured value) of a $C_{60}$ (fullerene) single film.
[FIG. 13] FIG. 13 is a diagram illustrating an equivalent circuit of a simulation model.
[FIG. 14] FIG. 14 includes diagrams illustrating a simulation result (current-voltage characteristics) based on an equivalent circuit in the case with a flat plate.
[FIG. 15] FIG. 15 includes diagrams illustrating a simulation result (current-voltage characteristics) based on an equivalent circuit in the case with a three-dimensional structure.
[FIG. 16] FIG. 16 is a diagram illustrating photoelectric conversion efficiency as a ratio to a flat plate.
[FIG. 17] FIG. 17 is a TEM photograph of an actually-produced solar cell.
[FIG. 18] FIG. 18 is a sectional diagram illustrating a modification of a solar cell according to the invention.
[FIG. 19] FIG. 19 includes schematic diagrams explaining a three-dimensional structure according to modification 1.
[FIG. 20] FIG. 20 is a diagram illustrating a result of ray-trace simulation in the case with a flat plate.
[FIG. 21] FIG. 21 is a diagram illustrating a result of ray-trace simulation in the case with a three-dimensional structure shown in FIG. 19.
[FIG. 22] FIG. 22 is a characteristic diagram illustrating a correlation of light absorptance between a case with a flat plate and a case with CCP.

[FIG. 23] FIG. 23 includes schematic diagrams explaining a three-dimensional structure according to modification 2.

[FIG. 24] FIG. 24 includes schematic diagrams each explaining a configuration of a convex portion according to another modification.

[FIG. 25] FIG. 25 is a schematic diagram explaining a three-dimensional structure according to modification 4.

MODE(S) FOR CARRYING OUT THE INVENTION

Hereinafter, modes for carrying out the invention will be described in detail with reference to the drawings. It is to be noted that the description is made in the following order.

1. Embodiment (Exemplary organic thin-film solar cell having three-dimensional structure on substrate surface).

2. Examples 1 to 5 (Examples of three-dimensional structures formed with master produced by laser processing.

3. Modification 1 (Exemplary three-dimensional structure in the form of retroreflective structure).

4. Modification 2 (Exemplary three-dimensional structure in the form of moth-eye structure).

5. Modification 3 (Exemplary solar cell having photoelectric conversion layer including inorganic material).

6. Modification 4 (Exemplary three-dimensional structure in the form of nano/micro hybrid structure).

7. Modification 5 (Exemplary structure having low-reflection film on light-incident surface side).

[Embodiment]

[Configuration of Solar Cell 1]

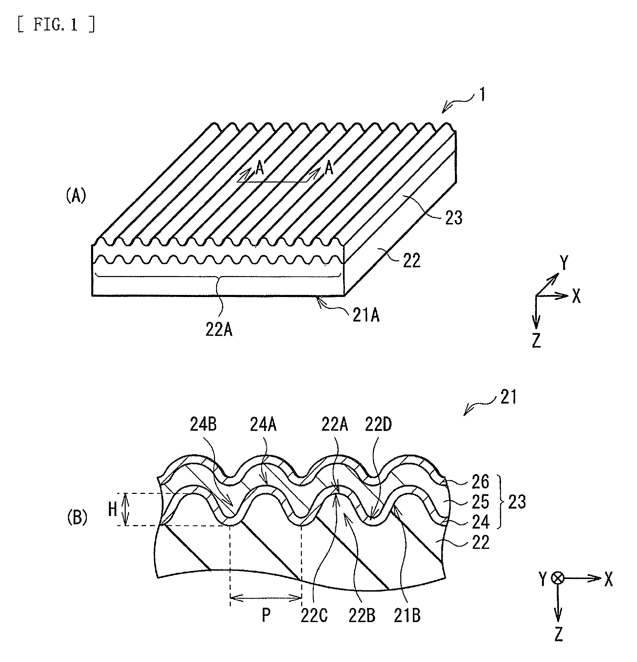

FIG. 1(A) perspectively illustrates a schematic configuration of a solar cell 1 (photoelectric conversion device) according to an embodiment of the invention, and FIG. 1(B) illustrates an exemplary sectional configuration in a direction of an arrow A-A in FIG. 1(A). The solar cell 1 is, for example, a photovoltaic device (an organic thin-film solar cell) that uses an organic compound thin-film for photoelectric conversion, and, for example, includes a transparent substrate 22 and a light receiving element 23. The transparent substrate 22 is in contact with the light receiving element 23, and a surface, on the side opposite to the light receiving element 23, of the transparent substrate 22 acts as a light incident surface 21A of the solar cell 1.

(Transparent Substrate 22)

The transparent substrate 22 includes a material transparent to light incident on a photoelectric conversion layer 25 described below, for example, glass or plastic. The transparent substrate 22 preferably has a light transmittance of approximately 70% or more to the light incident on the photoelectric conversion layer 25. The plastic that is allowed to be preferably used for the transparent substrate 22 includes polyethylene terephthalate (PET), polyethylene naphthalate (PEN), polyimide, polycarbonate (PC), and cycloolefin polymer (COP). The transparent substrate 22 is preferably rigid (self-supporting), but may be flexible. In the case with the flexible material, a three-dimensional structure described below may be formed by folding the transparent substrate 22 itself.

The transparent substrate 22 has a three-dimensional structure 22A (first three-dimensional structure) on its surface facing a transparent electrode 24. In the three-dimensional structure 22A, for example, a plurality of strip-like convex portions 22B extending in a first direction (Y-axis direction) in a plane of the substrate are regularly arranged along a direction (X-axis direction) orthogonal to the extending direction. As shown in FIG. 1(B), the convex portions 22B each preferably have a rounded top 22C (a convex curved surface). This is because, if the top 22C has a sharp-pointed shape, each portion of the light receiving element 23 corresponding to the top 22C is easily broken due to imperfect coverage and the like, leading to a short element life. In addition to the top 22C, a valley 22D defined by the adjacent two convex portions 22B may be rounded (a concave curved surface). The tops 22C and the valleys 22D are rounded in this way, allowing the three-dimensional structure 22A to have a wavy shape in the X axis direction.

It is to be noted that either or both of the tops 22C and the valleys 22D may be flat. Although a surface of each region between the tops 22C and the valleys 22D is preferably an inclined surface, it may be a vertical surface parallel to a stacked direction. Each convex portion 22B may have various shapes, for example, a semi-cylindrical column shape, a trapezoidal shape, and a polygonal column shape. All the convex portions 22B may have identical shapes. Alternatively, adjacent convex portions 22B may have different shapes. In addition, a plurality of convex portions 22B on the transparent substrate 22 may be grouped into two or more types of convex portions, and may have identical shapes for each of the types.

The scale of the convex portions 22B is of the order of micrometer or nanometer, and preferably of the order of nanometer. In detail, each width of the convex portions 22B (a pitch P in an arrangement direction) is, for example, 150 nm to 50 μm both inclusive, and is preferably of the visible wavelengths or less, and more preferably 200 nm to 300 nm both inclusive. In this embodiment, the convex portions 22B in the three-dimensional structure 22A are periodically arranged at an identical pitch P (=275 nm). The height H of each convex portion 22B is, for example, 30 nm to 100 μm both inclusive. The aspect ratio is desirably 0.2 to 2.0 both inclusive. This is because if the aspect ratio is more than 2.0, the light receiving element 23 is hard to be stacked on the transparent substrate 22. In contrast, if an aspect ratio is less than 0.2, a refractive index in a stacked direction steeply changes at an interface (interface 21B) between the transparent substrate 22 and the transparent electrode 24 and in the vicinity of the interface, leading to a high total reflectivity at the interface 21B. If the aspect ratio is 0.2 or more, the total reflectivity decreases at the interface 21B, leading to an increase in a ratio of light that enters the photoelectric conversion layer 25 from the light-incident surface 21A through the transparent substrate 22 and the transparent electrode 24.

The light receiving element 23, which receives light entering from a transparent substrate 22 side and extracts energy of the received light in the form of electric power, is provided on the surface having the three-dimensional structure 22A of the transparent substrate 22. As shown in FIG. 1(B), the light receiving element 23 includes, for example, the transparent electrode 24 (a first electrode), the photoelectric conversion layer 25, and a reflective electrode 26 (a second electrode) stacked in this order from a transparent substrate 22 side. Here, the light receiving element 23 as a whole, namely, the transparent electrode 24, the photoelectric conversion layer 25, and the reflective electrode 26 each have a three-dimensional structure (a three-dimensional structure 24A described below) in accordance with the three-dimensional structure 22A of the transparent substrate 22. However, all of the transparent electrode 24, the photoelectric conversion layer 25, and the reflective electrode 26 do not necessarily have the three-dimensional structure 24A, and only the surface of the transparent electrode 24, on the side opposite to the transparent substrate 22, needs to have the three-dimensional structure 24A, at least.

(Transparent Electrode 24)

The transparent electrode 24 is composed of a conductive material that is transparent to light received by the photoelectric conversion layer 25. Such a material includes, for example, ITO (indium tin oxide), SnO (tin oxide), and IZO (indium zinc oxide). The thickness of the transparent electrode 24 is, for example, 30 nm to 360 nm both inclusive.

The transparent electrode 24 is provided on the surface of the three-dimensional structure 22A of the transparent substrate 22, and has the three-dimensional structure 24A in accordance with the three-dimensional structure 22A on a surface, on the side opposite to the transparent substrate 22, of the transparent electrode 24. In other words, the three-dimensional structure 24A is substantially similar to the three-dimensional structure 22A. In detail, the three-dimensional structure 24A includes convex portions, each having a shape similar to that of the convex portion 22B, arranged in parallel in an X-axis direction. For example, in the three-dimensional structure 24A, the depth of a valley 24B defined by the adjacent two convex portions (distance from the top of the relevant convex portion to the bottom of the valley 24B) is equal to or smaller than the depth of the valley 22D (distance from the top of the convex portion 22B to the bottom of the valley 22D), and thus, the aspect ratio of the valley 24B is equal to or smaller than the aspect ratio of the valley 22D. To achieve good coverage of the photoelectric conversion layer 25, the transparent electrode 24, and the reflective electrode 26, the depth of a valley 24B is desirably equal to or smaller than the depth of the valley 22D, but the depth of a valley 24B may be conversely larger than the depth of the valley 22D. It is to be noted that the term "in accordance with" described herein not only refers to a case where the three-dimensional structures have the similar concavity and convexity but also refers to a case where the three-dimensional structures have different depths of valleys as described above.

(Photoelectric Conversion Layer 25)

The photoelectric conversion layer 25 has a function of absorbing incident light and converting energy of the absorbed light to electric power. The photoelectric conversion layer 25 includes a stack of p-type and n-type conductive polymers (not illustrate) forming a pn junction. In detail, the photoelectric conversion layer 25 includes CuPc (copper phthalocyanine) and a CuPc: $C_{60}$ film (co-evaporated film of copper phthalocyanine and fullerene) as p-type conductive films, a $C_{60}$ (fullerene) film as an n-type conductive film, and BCP (bathocuproine), which are stacked in this order from a transparent electrode 24 side. The thickness of the photoelectric conversion layer 25 is, for example, 100 nm or less. In addition, for example, LiF (lithium fluoride) and AlSiCu may be stacked on the photoelectric conversion layer 25, and LiF as a protective layer may be further stacked on the AlSiCu.

A constitutional material of the photoelectric conversion layer 25, however, is not limited to the above-described materials, and may include other organic compounds such as polymers.

The photoelectric conversion layer 25 is provided on the surface of the three-dimensional structure 24A of the transparent electrode 24, and has a structure (the three-dimensional structure 24A) that is substantially in accordance with the three-dimensional structure 22A on a surface, on the side opposite to the transparent substrate 22, of the photoelectric conversion layer 25. In other words, the photoelectric conversion layer 25 has a surface shape waving in the order of nanometer, for example. As a result, surface area per unit area of the photoelectric conversion layer 25, as viewed from a stacked direction, increases compared with a case where the photoelectric conversion layer 25 is provided on a flat plane. It is to be noted that the photoelectric conversion layer 25 may be provided on the entire surface of the transparent electrode 24, or may be distributed in a certain pattern. The form of the pattern may be various patterns such as a chessboard pattern and a stripe pattern without limitation.

(Reflective Electrode 26)

The reflective electrode 26 includes a material that reflects light incident on the photoelectric conversion layer 25 at a high reflectivity, for example, includes one or more of aluminum (Al), silver (Ag), platinum (Pt), gold (Au), chromium (Cr), tungsten (W), and nickel (Ni). The reflective electrode 26 is provided on the surface (wavy surface) of the photoelectric conversion layer 25, and has a structure (the three-dimensional structure 24A) that is substantially in accordance with the three-dimensional structure 22A on a surface, on the side opposite to the transparent substrate 22, of the reflective electrode 26. A layer including lithium fluoride (LiF) may be provided on the photoelectric conversion layer 25 side, of the reflective electrode 26 (for example, between the layer including BCP and the reflective electrode 26)

[Method of Manufacturing Solar Cell 1]

The above-described solar cell 1 is produced, for example, in the following way. Specifically, first, the transparent substrate 22 having the surface having the three-dimensional structure 22A is produced, and then the transparent electrode 24 is deposited by, for example, a sputter process on the surface (the surface having the three-dimensional structure 22A) of the transparent substrate 22. The photoelectric conversion layer 25 having the above-described stacked structure and the reflective electrode are then formed in this order on the formed transparent electrode 24 by, for example, a vacuum evaporation process. This is the end of formation of the solar cell 1 shown in FIG. 1(A). A specific method of producing the transparent substrate 22 having the above-described three-dimensional structure 22A is now described in detail with reference to the drawings.

(Production of Transparent Substrate 22)

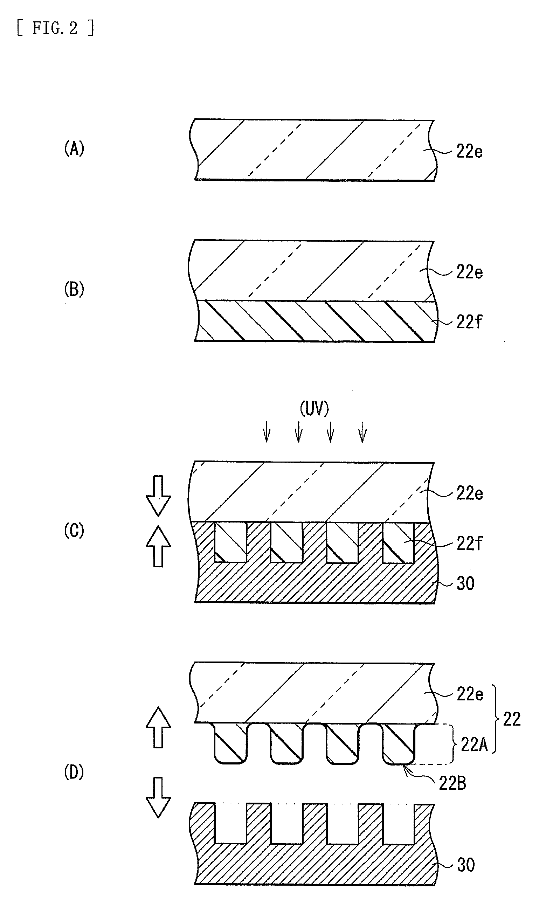

FIGs. 2(A) to 2(D) illustrates an outline of a production process of the transparent substrate 22 of the solar cell 1 in the order of process. First, as shown in FIG. 2(A), a base material 22e of the transparent substrate 22 is prepared, and then, as shown in FIG. 2(B), a resin layer 22f is applied on one surface of the base material 22e. For the base material 22e, the above-described material, such as glass and plastic, of the transparent substrate 22 is used. For the resin layer 22f, ultraviolet curable resin or thermosetting resin is used, for example. Here, description is made on a case where the ultraviolet curable resin is used for the resin layer 22f. As shown in FIG. 2(C), a die (master 30) having a reverse pattern of the concavity and convexity of the three-dimensional structure 22A is then pressed to the surface of the formed resin layer 22f, and the surface is irradiated with, for example, ultraviolet rays UV so that the resin layer 22f is cured. As shown in FIG. 2(D), the master 30 is then separated from the resin layer 22f, so that the reverse pattern on the master 30 is transferred to the resin layer 22f.

It is to be noted that the resin layer 22f need not be necessarily provided, and the reverse pattern on the master 30 may be directly transferred to the base material 22e. The base material 22e and the resin layer 22f may be provided directly in contact with each other. Alternatively, for example, an anchor layer or the like may be provided between the base material 22e and the resin layer 22f to enhance adhesion between them.

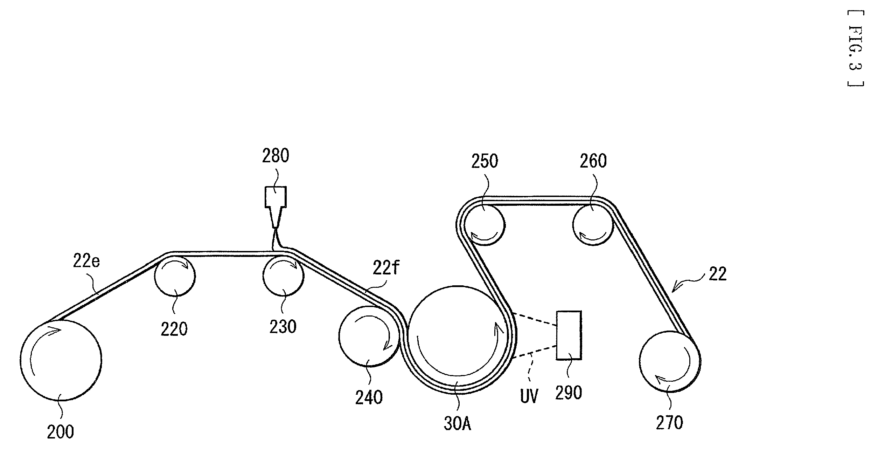

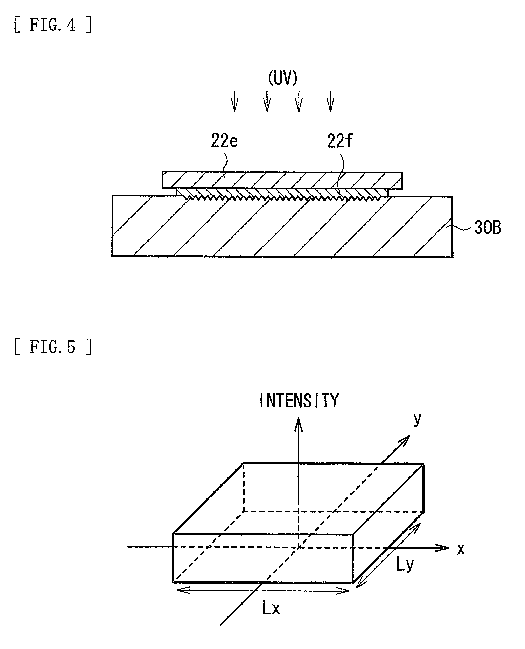

A more specific production process of the transparent substrate 22 using the above-described master 30 is now described. As the master 30, for example, a roll-like master (roll-like master 30A) as shown in FIG. 3 or a flat plate-like master (plate-like master 30B) as shown in FIG. 4 may be used.

(1. Case with Roll-like Master)

FIG. 4 illustrates an exemplary apparatus for so-called roll-to-roll formation of a fine concave-convex structure. In this process, first, the base material 22e is wound off from an unwinding roll 200 and guided to a guide roll 230 via a guide roll 220, and, for example, an ultraviolet curable resin is dropped from a discharger 280, for example, to apply the resin layer 22f onto the surface of the base material 22e on the guide roll 230. The resin layer 22f is pressed to the circumferential face of the roll-like master 30A while the base material 22a having the resin layer 22f applied thereon is pressed by a nip roll 240.

Subsequently, the resin layer 22f is then irradiated with ultraviolet rays UV from an ultraviolet irradiator 290 to cure the resin layer 22f. A reversal pattern of a plurality of fine concave-convex structures (the three-dimensional structure 22A) is beforehand provided on the circumferential face of the roll-like master 30A by a process described below. Thus, the resin layer 22f is pressed to the circumferential face of the roll-like master 30A and cured as described above, and thereby the reverse pattern on the roll-like master 30A is transferred to the resin layer 22f. The ultraviolet irradiator 290 applies the ultraviolet rays UV to a region in contact with the roll-like master 30A of the base material 22e that has been supplied from the unwinding roll 200 and has passed through the nip roll 240.

The base material 22e and the resin layer 22f are then separated from the roll-like master 30A with a guide roll 250, and then wound up on a winding roll 270 via a guide roll 30A. In this way, the transparent substrate 22 having the three-dimensional structure 22A on its surface may be produced. This roll-to-roll production using the roll-like master is advantageous in mass-productivity.

For such roll-to-roll production of the transparent substrate 22, for example, a flexible film-like or sheet-like material is preferably used as a material of the base material 22e. Such a material includes, for example, polyethylene terephthalate, polyethylene naphthalate, polycarbonate, polyimide, and COP. The COP includes, for example, ZEONOR and ZEONEX (registered trademarks of ZEON CORPORATION) and ARTON (a registered trademark of JSR Corporation).

It is to be noted that any flexible material other than the above-described resin may be used for the base material 22e. In the case where the material of the base material 22e does not transmit ultraviolet rays, the roll-like master 30A may be composed of a material (for example, quartz) that transmits ultraviolet rays so that the ultraviolet rays are applied to the resin layer 22f from the inside of the roll-like master 210. In the case where a thermosetting resin is used for the resin layer 22f, for example, a heater can be provided in place of the ultraviolet irradiator 290.

(2. Case with Plate-like Master)

In the case where the plate-like master 30A is used, the resin layer 22f is formed on the base material 22e as described above, and then the plate-like master 30A is urged to the resin layer 22f, and the resin layer 22f is irradiated with the ultraviolet rays UV and thus cured. After that, the plate-like master 30B is separated from the resin layer 22f, so that the three-dimensional structure 22A is formed. Alternatively, the resin layer 22f may be directly applied on the surface of the plate-like master 30A, and then, the resin layer 22f may be cured while the base material 22e is urged onto the resin layer 22f. Alternatively, the pattern on the plate-like master 30A may be directly transferred onto the base material 22e without the resin layer 22f. It is to be noted that, in the case where the plate-like master 30A is used, a rigid material (glass, quartz, sapphire, silicon, and the like) may be used for the base material 22e, in addition to the flexible material used for the above-described roll-to-roll production.

(Production of Master 30)

A method of producing the above-described master 30 (the roll-like master 30A and the plate-like master 30B) is now described. The master 30 has a reversal pattern of the three-dimensional structure 22A, the reversal pattern being formed on the surface of a mother roll including, for example, a metal material such as NiP, Cu, and stainless steel, quartz, silicon, silicon carbide, and sapphire, by the following process, for example. Specifically, a production process of the master 30 may be, for example, (A) bite cutting, (B) photolithography, (C) laser processing, (D) processing with abrasive grains, and (E) replica formation.

In the embodiment, the pitch of the convex portions 22B is of the order of nanometer such as 275 nm and 150 nm as described above. In formation of such a microstructure of the order of nanometer, a preferable master production process is different depending on the pitch of the convex portions 22B. Specifically, when the pitch is, for example, 275 nm, the master 30 is preferably produced by bite cutting. When the pitch is, for example, 150 nm, the master 30 is preferably produced by photolithography. It is to be noted that when the microstructure is formed by laser processing, the scale of the pitch depends on a wavelength of laser light to be used. These master production processes are described in detail below.

(A. Bite Cutting)

The concave-convex pattern of the master 30 is formed by cutting with a bite. For example, a single-crystal diamond bite or a carbide tool is used as the bite. In this process, the reversal pattern of the three-dimensional structure 22A may be formed at a pitch of several hundred nanometers to several hundred micrometers through cutting of the surface of the mother roll with the bite. In detail, grooves, each groove having, for example, a V-shaped section, are formed at a pitch of 275 nm on a Ni-P plated surface, for example. The transparent substrate 22 having the three-dimensional structure 22A was produced using the master 30 produced in this way, and observed with an AFM (atom force microscope). The observation revealed formation of the grooves at a pitch of 275 nm.

(B. Photolithography)

The concave-convex pattern on the master 30 is formed by photolithography. A type of the photolithography typically includes an electron beam type and a two-beam interferometry type. In the electron beam type of them, a photoresist is applied on a surface of a mother roll, and then the photoresist is irradiated with the electron beam through a photomask for patterning, and then a desired pattern is formed through steps including development, etching, and the like. In the two-beam interferometry type, two laser beams are interferingly applied to form an interference fringe that is then used for lithography to form a pattern.

Such lithography may conform to production of a master in a small size (narrow pitch), which is hard to be produced by the bite cutting, for example, production of a master having a pattern at a 150 nm pitch. The transparent substrate 22 having the three-dimensional structure 22A was produced using the master 30 produced in this way, and subjected to AFM observation. The observation revealed formation of the grooves at a pitch of 150 nm.

(C. Laser Processing)

The concave-convex pattern of the master 30 is formed by laser processing. In detail, for example, an concave-convex pattern is drawn with an ultrashort pulse laser having a pulse width of one picosecond ($10^{-12}$ sec) or less, which is so-called femtosecond laser, on a surface of a mother metal such as SUS, Ni, Cu, Al, and Fe. In this patterning, a laser wavelength, a repetition frequency, a pulse width, a beam spot shape, polarization, intensity of laser applied to a sample, and laser scan speed are appropriately set, thereby a desired concave-convex pattern is allowed to be formed.

In detail, the laser wavelengths used for the processing are, for example, 800 nm, 400 nm, and 266 nm. While the repetition frequency is preferably large in the light of processing time, the repetition frequency may be, for example, 1000 Hz or 2000 Hz. The pulse width is preferably short, and is preferably about 200 femtoseconds ($10^{-15}$ sec) to one picosecond ($10^{-12}$ sec) both inclusive. The laser applied to a die has a rectangular beam spot shape, for example. It is to be noted that the beam spot may be shaped by, for example, an aperture or a cylindrical lens. The intensity distribution of the beam spot is preferably uniform as much as possible, for example, as shown in FIG. 5. This is because such uniform intensity distribution allows depths and the like of the grooves formed on the master 30 to be uniform in the plane. It is to be noted that, when a scan direction of laser is a y direction, Lx of the size (Lx, Ly) of the beam spot is determined according to a width of a concave portion (or a convex portion) to be processed (described below in Examples 4 and 5).

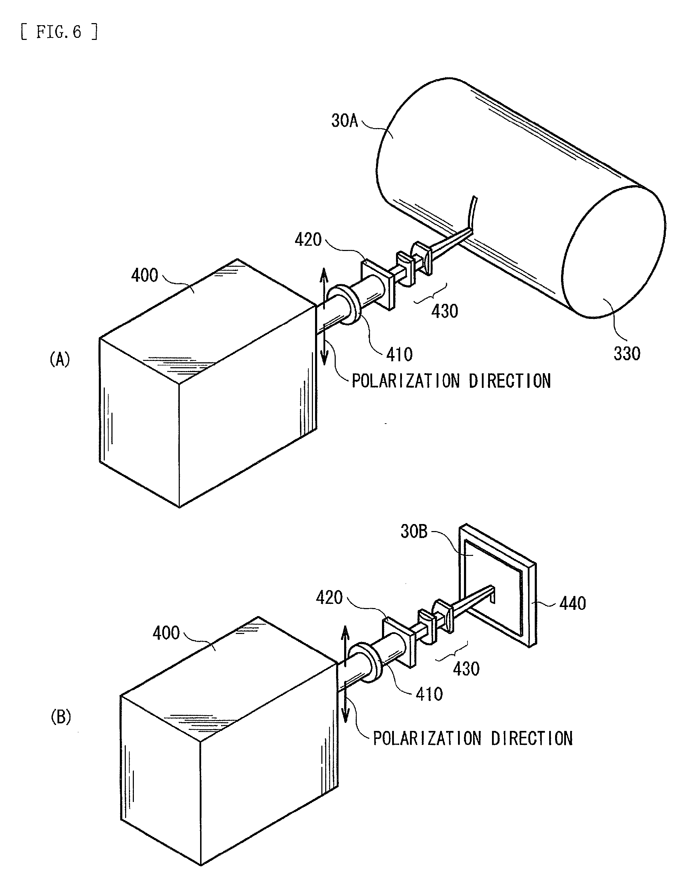

FIGs. 6(A) and 6(B) illustrate an exemplary optical layout used for laser processing. FIG. 6(A) illustrates a case of producing the roll-like master 30A as the master 30, and FIG. 6B illustrates a case of producing the plate-like master 30B as the master 30. In either case, a laser main body 400, a wave plate 410, an aperture 420, and a cylindrical lens 430 are disposed on a light axis, and light emitted from the laser main body 400 sequentially passes through the wave plate 410, the aperture 420, and the cylindrical lens 430, and applied to the maser 30 as an irradiation object.

The laser main body 400, for example, IFRIT (a trade name, manufactured by Cyber Laser Inc.), emits laser light that is linearly polarized in a vertical direction, for example. The laser wavelength is 800 nm, the repetition frequency is 1000 Hz, and the pulse width is 220 fs. The wave plate 410 (half-wave plate) rotates a polarization direction of the laser light as described above to convert the laser light into a linearly polarized light in a desired direction. The aperture 420 has a rectangular opening, and extracts part of the laser light. Since the intensity distribution of the laser light shows Gaussian distribution, only a portion in the vicinity of the center of the distribution is extracted, thereby uniform in-plane intensity distribution of the irradiation light is achieved. The cylindrical lens 430 includes two cylindrical lenses disposed such that their axial directions having refractive indicia are orthogonal to each other, and condenses the laser light to form a desired beam size.

To produce the roll-like master 30A by such an optical system, a mother roll to be the roll-like master 30A is wound on the circumferential face of the roll 330, and the roll 330 is rotated to scan the laser light on the roll-like master 30A. In contrast, to produce the plate-like master 30B, for example, a linear stage 440 attached with a mother plate of the plate-like master 30B is moved at a constant speed to scan the laser light on the plate-like master 30B. It is to be noted that the laser light may be scanned not only through the rotation of the roll 330 or the movement of the linear stage 440, but also through converse rotation or movement of the optical system from the laser main body 400 to the cylindrical lens 430.

In this way, the femtosecond laser is used, and a pattern is drawn while the beam spot shape of the laser is controlled, and thereby patterns may be collectively formed in one irradiation step. In addition, use of the femtosecond laser leads to formation of a groove extending along a direction orthogonal to the polarizing direction, and therefore a direction of the groove on the master 30 may be readily set through control of polarization. Consequently, a manufacturing process is simplified, and the master 30 is readily adapted to an increase in size. Specific numerical Examples using the laser processing are described below.

It is to be noted that, while the concave-convex pattern formed by the femtosecond laser has a desired periodical structure, slight fluctuation (i.e., a fluctuated periodical structure) may exist in the period or the direction of the concavity and convexity. In contrast, a pattern formed by another process such as electron beam lithography typically has no fluctuation. When a die having the fluctuated pattern as in the modification is used, to transfer the pattern to a base material, the fluctuated concave-convex pattern is also transferred to the base material.

(D. Processing with Abrasive Grains)

The pattern of the master 30 is formed using traces formed through processing with fixed abrasive grains or loose abrasive grains. In detail, the roll-like master 30A can be produced as follows, for example. Specifically, an unprocessed roll is rotated about its central axis, while a disk-shaped grinding wheel is rotated in a desired direction. In this process, alumina-based abrasive grains (grain size of about 1000 to 3000) are used for the grinding wheel, and the width of each grain surface of the grinding wheel needs to correspond to a pattern pitch. The transparent substrate 22 was produced using the roll-like master 30A produced in this way, and subjected to AFM observation. The observation revealed formation of the convex portions 22B at a pitch of several hundred nanometers to several hundred micrometers.

In contrast, to produce the plate-like master 30B, for example, an unprocessed plate is slid in one direction, while a disk-shaped grinding wheel is rotated in a desired direction. In this process, alumina-based grains (grain size of about 1000 to 3000) are used for the grinding wheel. The transparent substrate 22 was produced using the plate-like master 30B produced in this way, and subjected to AFM observation. The observation revealed formation of the convex portions 22B at a pitch of several hundred nanometers to several hundred micrometers.

(E. Formation of Replica)

The pattern of the master 30 (here, the roll-like master 30A) is formed by pressure transfer of a die (original master) having an concave-convex pattern having the same concave-convex shape as the relevant pattern. Specifically, the roll-like master 30A is formed (duplicated) using a replica from the original master.

In detail, first, a roll-like master having the concave-convex pattern is prepared. An unprocessed roll-like master 30A (mother roll) is then rotated about its central axis, while the original master is rotated such that its central axis is parallel to the rotational axis of the mother roll, and the two have the same rotational speed. The original master is then pressed to (an unground region of) a circumferential face of the mother roll, and thereby the concave-convex pattern of the original master is pressed and transferred to the mother roll. The transparent substrate 22 was produced using the roll-like master 30A produced in this way, and subjected to AFM observation. The observation revealed formation of the convex portions 22B at a pitch of several hundred nanometers to several hundred micrometers.

It is to be noted that if the roll-like master 30A is not usable due to abrasion and the like, a new roll-like master 30A is allowed to be produced from the original master, so that the transparent substrate 22 having the three-dimensional structure 22A is allowed to be continuously produced. Alternatively, the roll-like master 30A may be formed with the original master by so-called electroforming.

The master 30, produced by one of the processes (A) to (E) as described above, is used to produce the transparent substrate 22, thereby enabling ready formation of the transparent substrate 22 having the three-dimensional structure 22A including a plurality of convex portions 22B arranged in the order of nanometer, for example.

[Functions and Effects of Solar Cell 1]

In the embodiment, light (sunlight) enters from the light incident surface 21A and is received by the light receiving element 23 through the transparent substrate 22. In the light receiving element 23, when light is incident on the photoelectric conversion layer 25 through the transparent substrate 23, conduction electrons increase due to energy of the incident light, and holes are separated from electrons by an inner electrical field (hole-electron pairs are formed). Electric charges generated in this way are extracted to the outside through the transparent electrode 24 and the reflective electrode 26, thereby a photocurrent is generated, leading to power generation.

In the embodiment, the three-dimensional structure 22A having, for example, a regularity of the order of nanometer along the X-axis direction is provided on the surface on the transparent electrode 24 side of the transparent substrate 22. The surfaces of the transparent electrode 24, the photoelectric conversion layer 25, and the reflective electrode 26 each have the three-dimensional structure 24A in accordance with the three-dimensional structure 22A. The photoelectric conversion layer 25 has the surface shape in accordance with the three-dimensional structure 22A. Thereby, compared with a case where the surface of the transparent substrate is flat (the photoelectric conversion layer is flat), the photoelectric conversion layer 25 effectively absorbs incident light, and allows an electric field to be concentrated, causing an increase in current density.

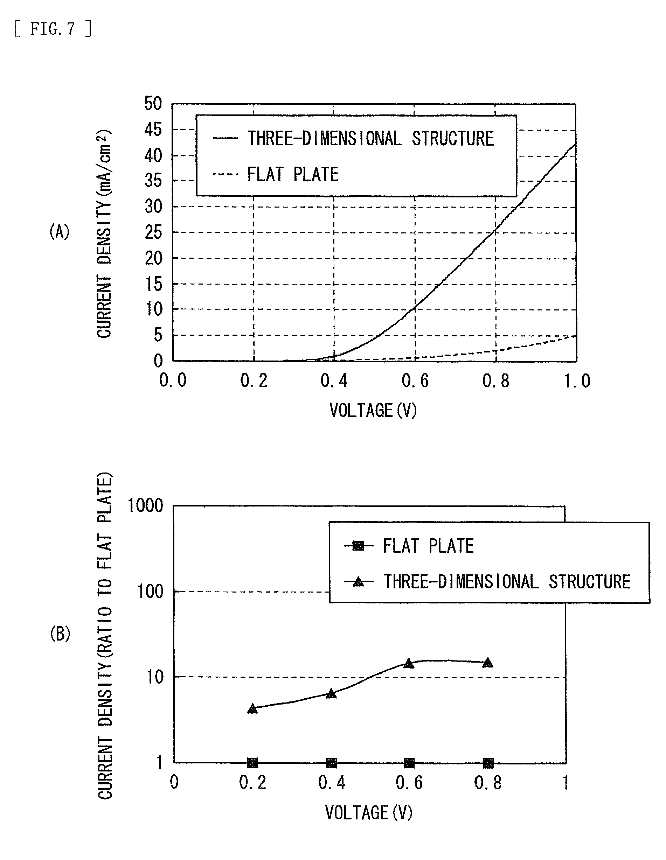

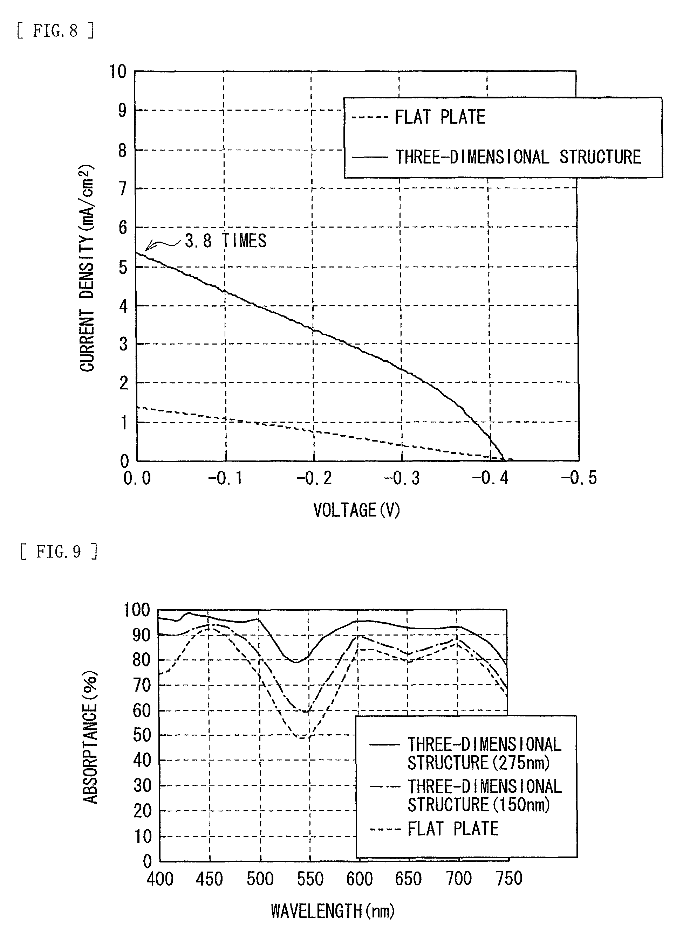

For example, as shown in FIGs. 7(A) and 7(B), in the case where the convex portions 22B are provided on the surface of the transparent substrate 22 at a pitch of 275 nm, the current density (mA/cm$^2$) with respect to voltage (V) is high compared with the case where the surface of the transparent substrate 22 is flat (flat plate). FIGs. 7(A) and 7(B) illustrate measured results of the current density in the photoelectric conversion layer 25 (without light irradiation). FIG. 8 illustrates measured results in the case of irradiation of light of 1 sun (=100 mW/cm$^2$). In this way, even in the case of light irradiation, the current density in the case with the concave portions 22B at a pitch of 275 nm is about 3.8 times as large as that in the case with a flat plate.

In addition, as shown in FIG.9, in each case of the concave portions 22B provided at a pitch of 275 nm and a pitch of 150 nm, light absorptance (%) is high compared with that in the case with a flat plate. FIG. 9 illustrates a result of simulation of the light absorptance of the solar cell 1 as a whole by the rigorous coupled wave analysis (RCWA).

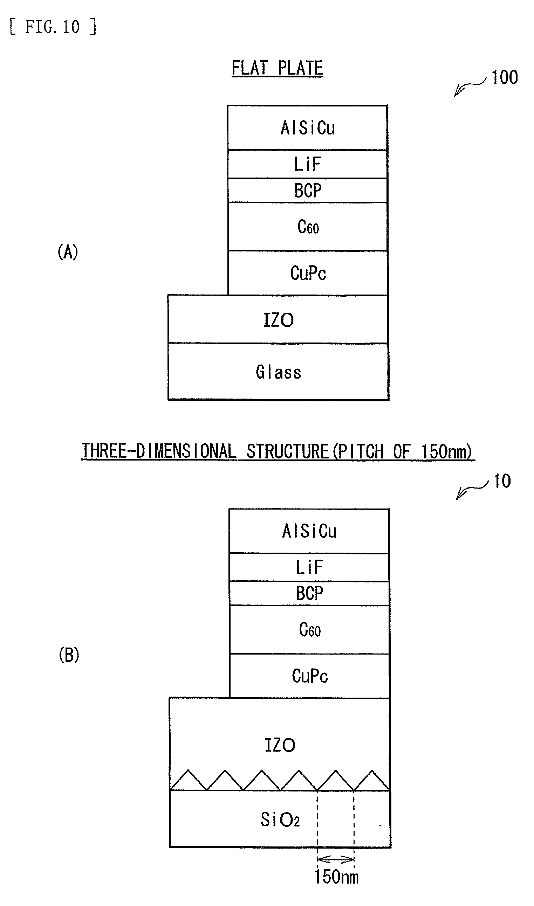

Here, the following simulation is performed for a device structure 100 including a flat plate as the transparent substrate (FIG. 10(A)) and for a device structure 10 including the transparent substrate 22 having the three-dimensional structure 22A (FIG. 10(B)). In the device structure 100, IZO subjected to oxygen plasma ashing (120 nm), CuPc (30 nm), $C_{60}$ (40 nm), BCP (10 nm), LiF (1 nm), AlSiCu (100 nm), and an undepicted LiF protective layer (40 nm) are stacked in this order on a flat glass substrate (AN100 (a trade name of ASAHI GLASS CO., LTD.). In contrast, in the device structure 10, IZO subjected to oxygen plasma ashing (360 nm), CuPc (30 nm), $C_{60}$ (40 nm), BCP (10 nm), LiF (1 nm), AlSiCu (100 nm), and an undepicted LiF protective layer (40 nm) are stacked on a quarts ($SiO_2$) substrate having a three-dimensional structure (at a pitch of 150 nm). It is to be noted that values in the parentheses show thicknesses of the layers.

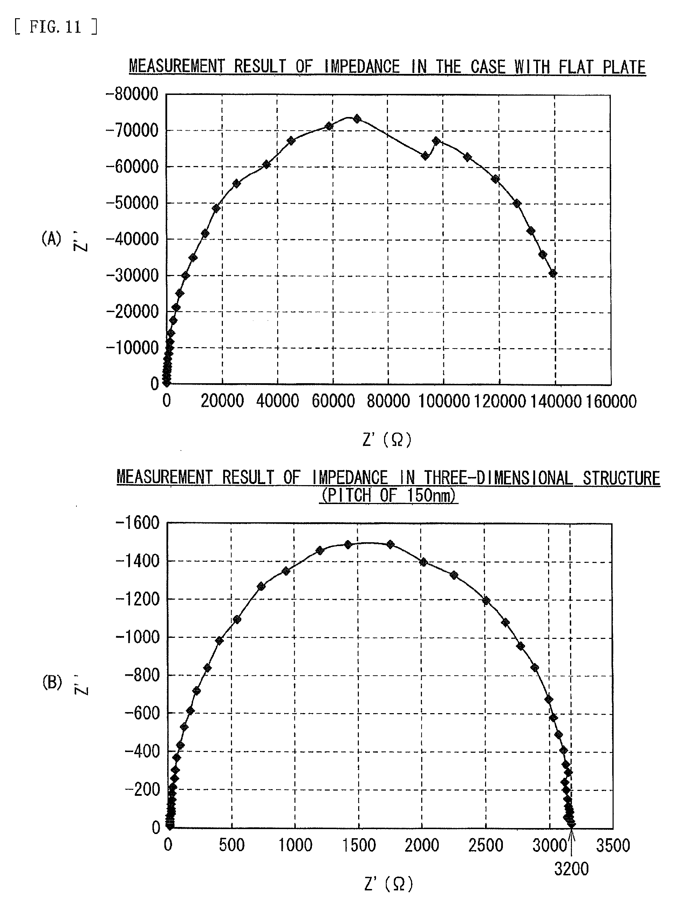

FIG. 11 illustrates complex plane impedance (measured values), where FIG. 11(A) shows the complex plane impedance of the device structure 100 with the flat plate, and FIG. 11(B) shows that of the device structure 10 with the three-dimensional structure (at a pitch of 150 nm). The vertical axis shows an imaginary number, and a horizontal axis shows a real number (a resistance value). As shown in FIGs. 11(A) and 11(B), while the resistance value is 140 kΩ in the device structure 100 with the flat plate, the resistance value is 3.2 kΩ in the device structure 10 with the three-dimensional structure. This reveals that use of the three-dimensional structure reduces the resistance value by about 98%.

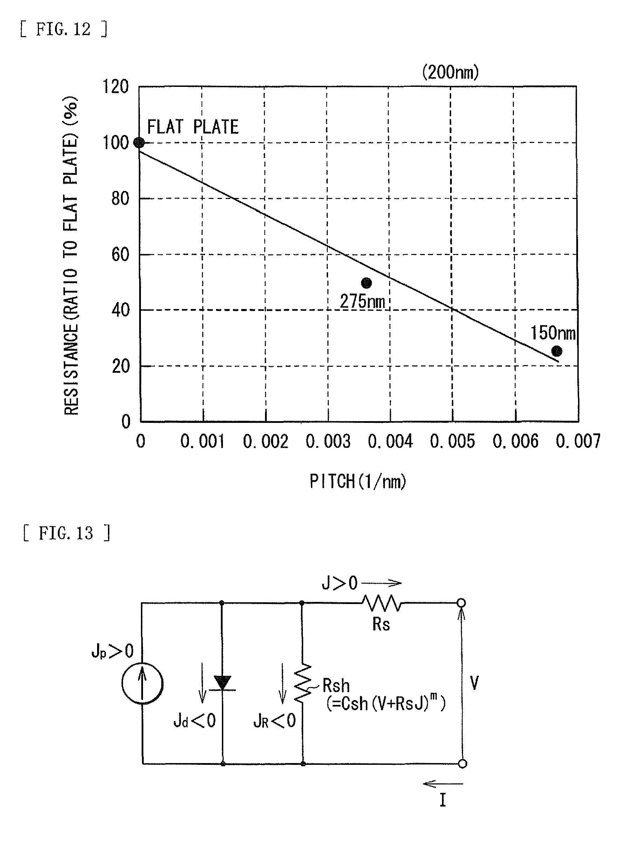

The resistance values of $C_{60}$ single-layer films of the device structures 100 and 10 were measured. As a result, the measured resistance values were 0.45 kΩ and 0.90 kΩ in the device structures with the three-dimensional structures (150 nm and 275 nm), which were lower than the measured resistance value in the device structure with the flat plate. FIG. 12 illustrates a relationship between each resistance value (a measured value, a ratio supposing the value is 100% for the flat plate) and the reciprocal of each pitch. It is to be noted that FIG. 12 also illustrates a resistance value in the device structure 10 with the pitch of the three-dimensional structure of 275 nm, in addition to the values in the device structures 100 and 10.

As shown in FIG. 12, the resistance values of the devices with the three-dimensional structures (150 nm and 275 nm) are 25% and 50% of that of the device with the flat plate, respectively.

To theoretically analyze this result, simulation is performed based on an equivalent circuit shown in FIG. 13. In the equivalent circuit of a solar cell, when light is not irradiated, as the simplest model, only a current source (Jp) and a diode (not an ideal diode) should be considered while a resistance component is neglected. In this case, a dark current J (a current- voltage characteristics without light irradiation) of the solar cell is expressed as the following expression (1), where Jo is reverse-direction saturation current, e is elementary charge, V is voltage, n is ideal diode factor, k is Boltzmann's constant, and T is temperature.) It is to be noted that the series resistance Rs is a resistance component during current flow through the device. Here, the dark current J is equal to Jd.

[Numerical Expression 1]

$$J = -J_0 \left\{ \exp\left( \frac{e\,(V + R_s J)}{nkT} \right) - 1 \right\} \qquad \cdots\cdots (1)$$

$$J = J_p - J_0 \left\{ \exp\left( \frac{e\,(V + R_s J)}{nkT} \right) - 1 \right\} - C_{sh}(V + R_s J)^m \qquad \cdots\cdots (2)$$

According to the Sah-Noyce-Shockley theory (n: the ideal diode factor depends on a recombination position of an electron and a hole), the following consideration is given.

n=1: recombination occurs in an n-type region and a p-type region (neutral region).

n=2: recombination occurs in a space-charge layer (depleted layer) through a recombination center within a band gap.
n>2: recombination occurs through other mechanisms (for example, a tunnel effect).

To extract a photocurrent through light irradiation, a parallel resistance $R_{sh}$ is taken into consideration in addition to a series resistance $R_s$ to approximate to an actual device. The series resistance $R_s$ is a resistance component during current flow through the device as described above, and the device performance is improved with a decrease in the series resistance $R_s$. The parallel resistance $R_{sh}$ is formed due to a leakage current around the pn junction, and the device performance is improved with an increase in the parallel resistance $R_{sh}$. In consideration of these resistance components, the current-voltage characteristics of the solar cell including these resistance characteristics during light irradiation is expressed as the above-described expression (2), where $C_{sh}$ is capacitance of a capacitor.

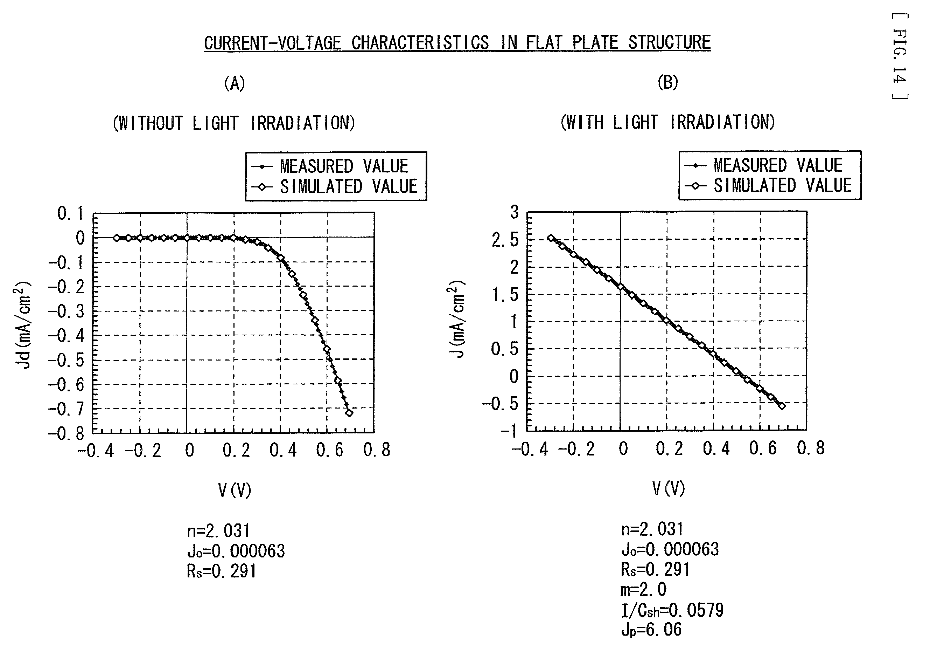

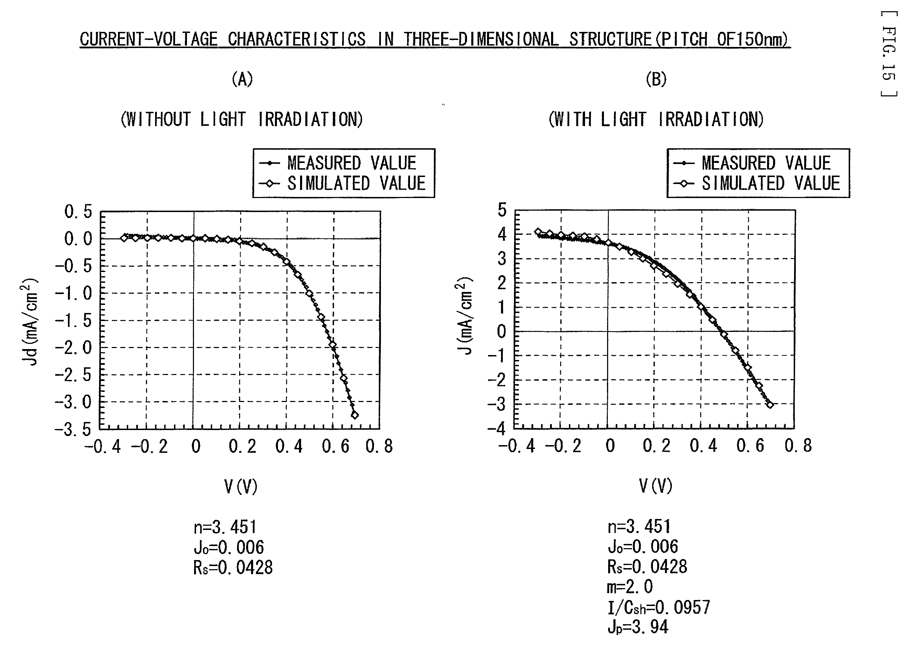

In the current--voltage characteristics based on such an equivalent circuit, as shown in FIGs. 14 and 15, the above-described parameters are determined through fitting such that the simulated values are substantially equal to the measured values. FIG. 14 illustrates the characteristics of the device structure 100 with the flat plate during no light irradiation (A) and during light irradiation (B). FIG. 15 illustrates the characteristics of the device structure 10 with the three-dimensional structure (150 nm pitch) during no light irradiation (A) and during light irradiation (B). This reveals that the device structure with the three-dimensional structure achieves the series resistance $R_s$ of $0.0428*10^{-3}$ $\Omega cm^2$ that is about 85% lower than that ($0.291*10^{-3}$ $\Omega cm^2$) in the device structure with the flat plate. Specifically, a current is readily extracted from the solar cell.

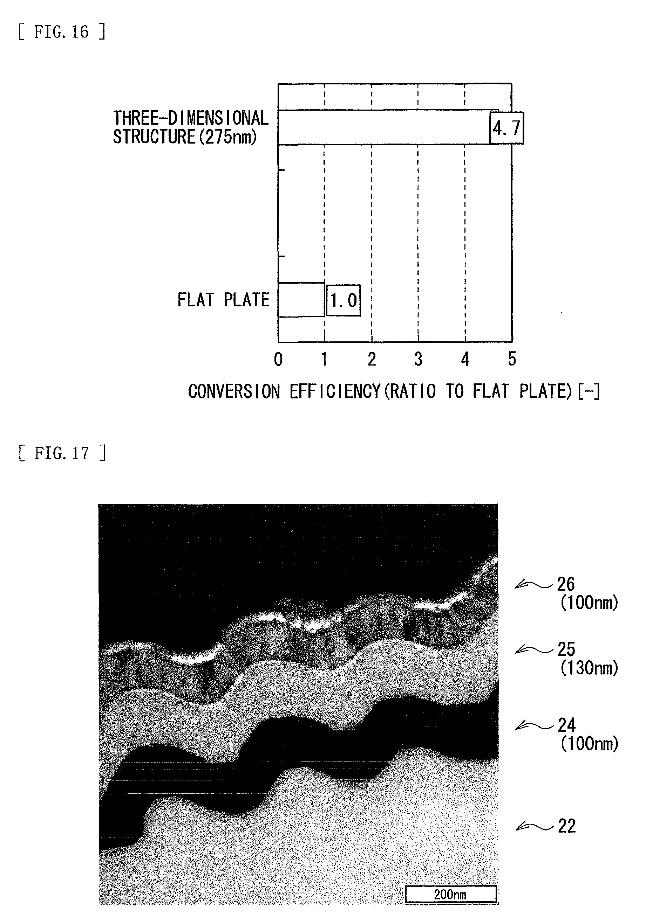

In this way, a plurality of convex portions 22B having, particularly, a regularity of the order of nanometer (for example, a pitch of 275 nm and of 150 nm) are provided on the surface of the transparent substrate 22 as the three-dimensional structure 22A, and thereby the light absorptance and current density of the photoelectric conversion layer 25 may be increased compared with in the case with the flat transparent substrate. Such increase in the current density is estimated to be caused by the reduction in resistance of the device as a whole due to concentration of an electric field as described above. As a result, the generated current is allowed to be efficiently extracted. In addition, for example, as shown in FIG. 16, this achieves the photoelectric conversion efficiency that is 4.7 times as high as that in the case with the flat plate, at the pitch of the convex portions 22B of 275 nm. It is to be noted that FIG. 17 shows a TEM. (transmission electron microscope) photograph of the solar cell 1 produced with the pitch of the convex portions 22B of 275 nm. In this way, the device is structured such that the concave-convex shape (three-dimensional structure 22A) is provided on the surface of the transparent substrate 22, and the transparent electrode 24, the photoelectric conversion layer 25, and the reflective electrode 26 are stacked in order with the surface shape (three-dimensional structure 24A) in accordance with the three-dimensional structure 22A.

As described above, in the embodiment, the three-dimensional structure 22A having, for example, the regularity of the order of nanometer is provided on the surface of the transparent substrate 22, and the transparent electrode 24, the photoelectric conversion layer 25, and the reflective electrode 26 are provided in this order on the surface, each having the three-dimensional structure 24A in accordance with the three-dimensional structure 22A. The photoelectric conversion layer 25 has the surface shape in accordance with the three-dimensional structure 22A, and thereby the light absorptance of incident light and current density of the photoelectric conversion layer 25 may be increased compared with in the case where the surface of the transparent substrate is flat (the photoelectric conversion layer is flat). Consequently, photoelectric conversion efficiency of the solar cell, particularly, the solar cell such as the organic thin-film solar cell, may be improved.

Description is now made on numerical Examples of the transparent substrate 22 in the embodiment (examples using the master 30 produced by the above-described (C) laser processing).

(Example 1)

In Example 1, a plate-like master 30B was produced using the femtosecond laser according to the above-described laser processing process. A transparent substrate 22 having the three-dimensional structure 22A was then produced using the plate-like master 30B. In this process, a mirror-finished SUS having a thickness of 1 mm was used for a mother plate of the plate-like master 30B, and a ZEONOR film (ZF14 manufactured by ZEON CORPORATION) was used for the base material 22e of the transparent substrate 22. To transfer a pattern to the base material 22e, first, the plate-like master 30B was subjected to release treatment, and then a UV-curing acrylic resin liquid (TB3042, manufactured by ThreeBond Co., Ltd.) was spread as the resin layer 22f, and then the resin layer 22f was subjected to UV irradiation from a base material 22e side so as to be cured while the base material 22e was pressed onto the resin layer 22f. The base material 22e and the resin layer 22f were then separated from the plate-like master 30B. The surface of the transparent substrate 22 produced in this way was subjected to AFM observation, which revealed formation of the convex portions 22B at a pitch of several hundred nanometers to several hundred micrometers.

(Example 2)

In Example 2, a transparent substrate 22 having the three-dimensional structure 22A was produced on a base material 22e using a material different from that in the Example 1. A triacetylcellulose (TAC) film (FT-80SZ manufactured by PANAC CO., LTD.) was used for the base material 22e. It is to be noted that conditions other than the material of the base material 22e were similar to those in the Example 1. In the Example, the surface of the transparent substrate 22 was also subjected to AFM observation, which revealed formation of the convex portions 22B at a pitch of several hundred nanometers to several ten micrometers.

(Example 3)

In Example 3, a roll-like master 30A was produced using the femtosecond laser according to the above-described laser processing process. A transparent substrate 22 having the three-dimensional structure 22A was then produced using the roll-like master 30A. In this process, a mirror-finished SUS roll, having a diameter of 100 mm and a width of 150 mm, was used for the mother roll of the roll-like master 30A, and a ZEONOR roll film (ZF14 manufactured by ZEON CORPORATION) was used for the base material 22e of the transparent substrate 22. To transfer the concave-convex pattern to the base material 22e, first, the roll-like master 30A was subjected to release treatment, and then a UV-curing acrylic resin liquid (TB3042, manufactured by ThreeBond Co., Ltd.) was spread as the resin layer 22f. Then, while the base material 22e was urged onto the resin layer 22f, the resin layer 22f was subjected to UV irradiation at a power of 1500 mJ/cm$^2$ (at a wavelength of 365 nm) from a base material 22e side such that a film forming rate is 0.6 m/min. The base material 22e and the resin layer 22f were then separated from the roll-like master 30A and wound up. The surface of the transparent substrate 22 produced in this way was subjected to AFM observation, which revealed formation of the convex portions 22B at a pitch of several hundred nanometers to several hundred micrometers.

(Examples 4 and 5)

In Examples 4 and 5, while conditions of the femtosecond laser were set as follows, masters 30 were produced and the surfaces of the masters 30 were observed.

(1) a case where beam spot size Lx=530 $\mu$m

Concave-convex patterns were formed using respective masters 30 including SUS304, SUS420J2, and NiP as mother materials. In this process, setting was made in each case such that beam size Lx was 530 $\mu$m, beam size Ly was 30 $\mu$m, power was 156 mW, and stage speed was 3 mm/sec. It is to be noted that NiP was plated on SUS for use.

(2) a case where beam spot size Lx=270 $\mu$m

An concave-convex pattern was formed using a master 30 including SUS304 as a mother material with setting of beam size Lx of 270 $\mu$m, beam size Ly of 220 $\mu$m, power of 200 mW, and stage speed of 6 mm/s.

In each of the cases (1) and (2), the pitch of the grooves of the formed concave-convex pattern of the master 30 was about 700 nm, and the depth was about 50 to 250 nm. In this way, the size (Lx) of the irradiated laser beam spot and other laser conditions are appropriately set, and thereby grooves having desired pitch and depth may be patterned on the master 30.

Modifications (modifications 1 and 2) of the convex portions of the three-dimensional structure in the embodiment are now described. Although the structure where a plurality of convex portions extend in one direction in a plane of a substrate has been exemplified as the three-dimensional structure in the embodiment, this is not limitative, and the three-dimensional structure may include a structure where a plurality of convex portions are distributed in two directions (X and Y directions) (two-dimensionally arranged) in a plane of a substrate. The following modifications each show an example of convex portions that are two-dimensionally arranged in a plane of a substrate, where components similar to those in the embodiment are designated by the same numerals and description of them are appropriately omitted.

[Modification 1]

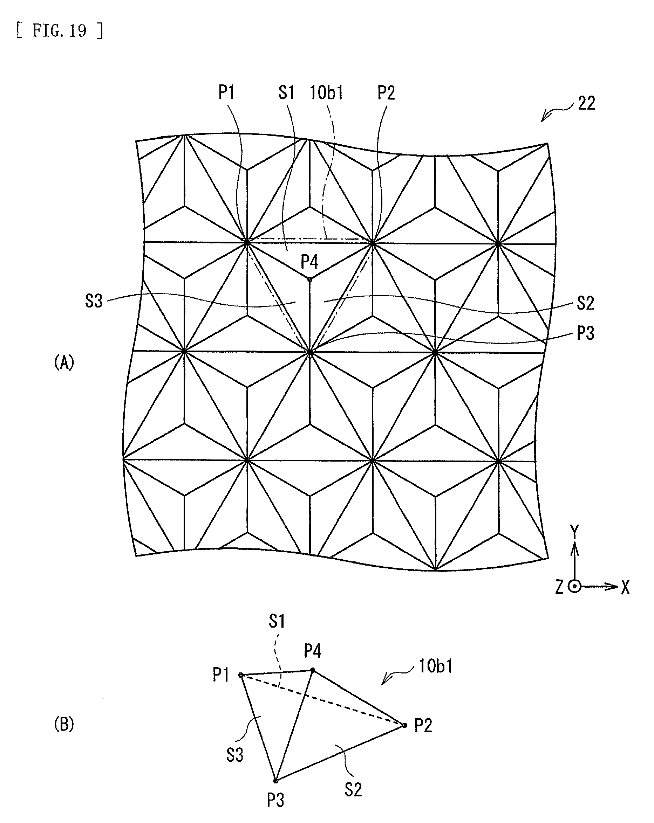

FIGs. 19(A) and 19(B) are schematic views that explain a three-dimensional structure (retroreflective structure) according to modification 1, where FIG. 19(A) is a schematic view as viewed from a top, and FIG. 19(B) is a perspective schematic view of one convex portion. In the modification, a three-dimensional structure includes a plurality of convex portions 22h1 each being a so-called corner cube prism (CCP), and the corner cube prisms are regularly arranged on a substrate plane.

In detail, convex portions 22h1, each having a triangular pyramid shape as shown in FIG. 19(B), are regularly arranged in X and Y directions in a plane of a substrate as shown in FIG. 19(A). As a result, in each convex portion 22h1, three faces, other than a bottom surface, S1, S2, and S3 act as reflective surfaces, and light incident along a Z direction is multiply reflected by the faces S1, S2, and S3. Examples of a structure causing such multiple reflection include a retroreflective structure. The pitch of the convex portions 22h1 is, for example, more than 0.8 $\mu$m and less than 250 $\mu$m , which is equal to or larger than visible wavelengths, and the height thereof is set to an appropriate value depending on size of the pitch. A pitch of the convex portions 22h1 of more than 250 $\mu$m increases the thickness required for the transparent substrate, thereby resulting in loss of flexibility. A pitch of the convex portions 22h1 of less than 250 $\mu$m increases the flexibility, thus facilitating roll-to-roll production, and thus eliminating need of so-called batch production. Moreover, a pitch of 20 $\mu$m to 200 $\mu$m both inclusive further improves the productivity.

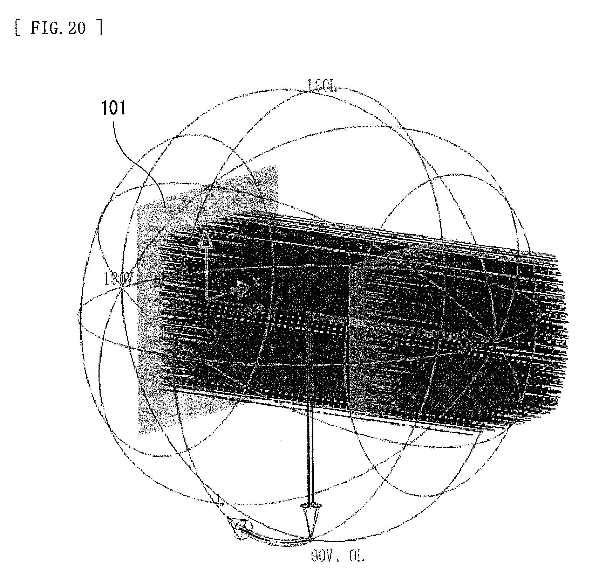

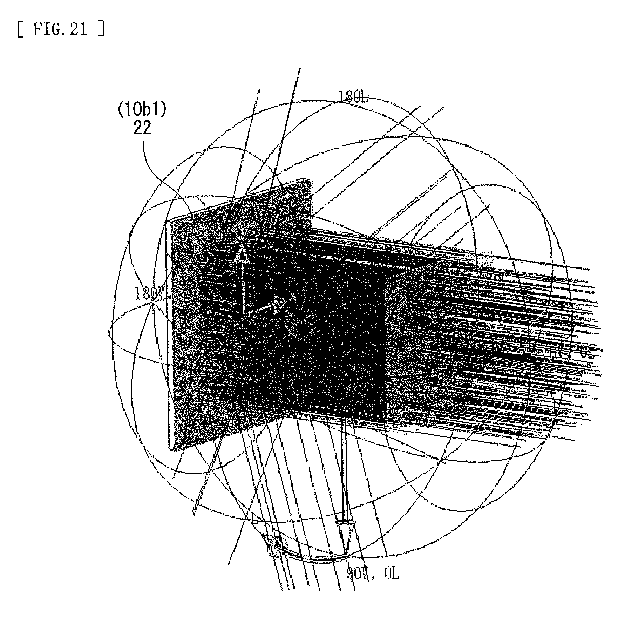

FIG. 20 illustrates a result of ray-trace simulation for light incidence in a comparative example (with a flat plate (without the three-dimensional structure)). FIG. 21 illustrates a result of ray-trace simulation in an Example (with the three-dimensional structure using CCP). As shown in the drawings, in the case with the flat plate as in the comparative example, reflection occurs only once as regular reflection, which reduces the amount of light absorption (increases light that is not absorbed by the photoelectric conversion layer). In contrast, in the Example using the CCP, the number of light incidence on the photoelectric conversion layer increases through multiple reflection, leading to an increase in the amount of light absorption compared with the case with the flat plate.

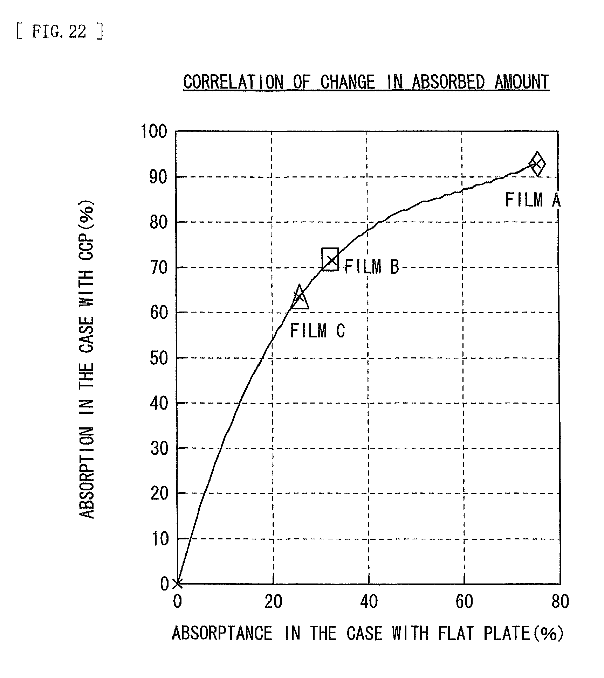

FIG. 22 illustrates a correlation of the amount of light absorption between the case with the flat plate and the case with the CCP. It is to be noted that films A to C having different conversion efficiencies (conversion efficiency: A>B>C) were used for the simulation. As shown in the drawing, the absorptance in the case with the flat plate is plotted in the horizontal axis, and the absorptance in the case with the CCP us plotted in the vertical axis. As a result, the absorptance is high in the case with the CCP compared with in the case with the flat plate in each of the films A to C. In addition, such an effect of an improvement in the absorptance is more obvious in the case with a material having relatively low conversion efficiency (the absorptance improvement effect by the CCP: C>B>A).

The three-dimensional structure on the substrate surface is not limited to the structure where the convex portions extend in one direction as described in the embodiment, and may be a structure where the CCP are two-dimensionally arranged as the convex portions as in this modification. In such a case, an equivalent advantage to that in the embodiment is allowed to be provided. In particular, in this case, incident light is reflected several times on the reflective surfaces of the CCP, thus increasing the number of light incidence on the photoelectric conversion layer. As a result, the light absorptance of the light receiving element increases, enabling an increase in electric generating capacity to be obtained.

[Modification 2]

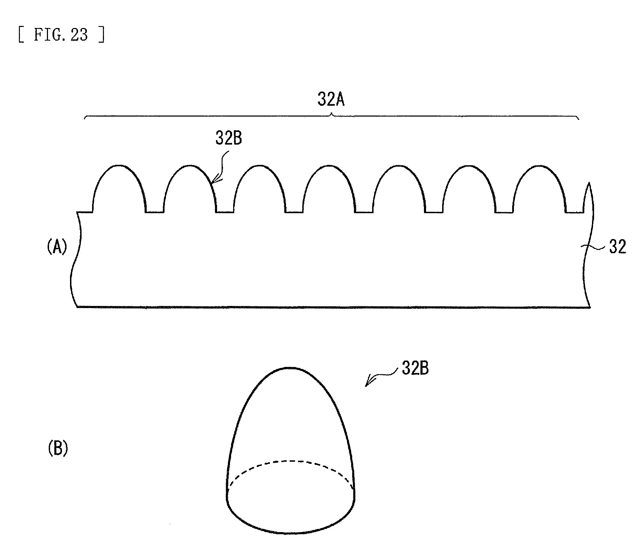

FIGs. 23(A) and 23(B) are schematic views that explain a three-dimensional structure (moth-eye structure) according to modification 2, where FIG. 23(A) is a sectional view of a substrate, and FIG. 23(B) is a perspective schematic view of one convex portion. In a three-dimensional structure 32A of this modification, a plurality of bell-shaped (semielliptical section) convex portions 32b are regularly arranged. The pitch of the convex portions 32b is of the order of nanometer, and is preferably more than 200 nm and equal to or less than 300 nm. The aspect ratio is desirably 0.6 to 1.2 both inclusive. The reason for this is as follows. In the case of a three-dimensional structure (for example, a moth-eye structure) having a pitch of visible wavelengths or less (for example, 800 nm or less), if an aspect ratio is more than 1.2, the light receiving element 23 is hard to be stacked on the transparent substrate 22. In contrast, if an aspect ratio is less than 0.6, a refractive index in a stacked direction steeply changes at an interface (interface 21B) between the transparent substrate 22 and the transparent electrode 24 and in the vicinity of the interface, leading to a high total reflectivity at the boundary 21B. If the aspect ratio is 0.2 or more, the total reflectivity decreases at the interface 21B, leading to an increase in a ratio of light that enters the photoelectric conversion layer 25 from the light-incident surface 21 A through the transparent substrate 22 and the transparent electrode 24.

The three-dimensional structure may be formed with the moth-eye structure as in the modification. In such a case, an equicalent advantage to that in the embodiment may be provided. In addition, the three-dimensional structure is used for a device surface (a interface between air and glass) of a solar cell, thereby light absorptance of the light receiving element is allowed to be increased utilizing an effect by Fresnel reflection, leading to an increase in electric generating amount.

[Modification 3]

While the embodiment and others have been described with the exemplary organic thin-film solar cell as the photoelectric conversion device of the invention, this modification is described with an exemplary solar cell including an inorganic material for the photoelectric conversion layer (for example, an amorphous silicon solar cell). In detail, the photoelectric conversion layer may include a p-type amorphous silicon film (for example, 13 nm in thickness), an i-type amorphous silicon film (for example, 250 nm in thickness), and an N-type amorphous silicon film (for example, 30 nm in thickness), which are stacked in this order from a side of a transparent substrate 22 having a three-dimensional structure 22A similar to that as described above. Such a photoelectric conversion layer is allowed to be deposited by plasma CVD while the transparent substrate 22 is heated at 170°C. It is to be noted that components other than the photoelectric conversion layer are similar to those in the embodiment.

However, the inorganic material constituting the photoelectric conversion layer is not limited to the above-described material. In addition, the photoelectric conversion layer may be deposited by a vapor deposition process such as thermal CVD or a sputtering process, in addition to the plasma CVD. In addition, an organic compound such as other polymers may be included in part of the inorganic constitutional material.

[Modification 4]

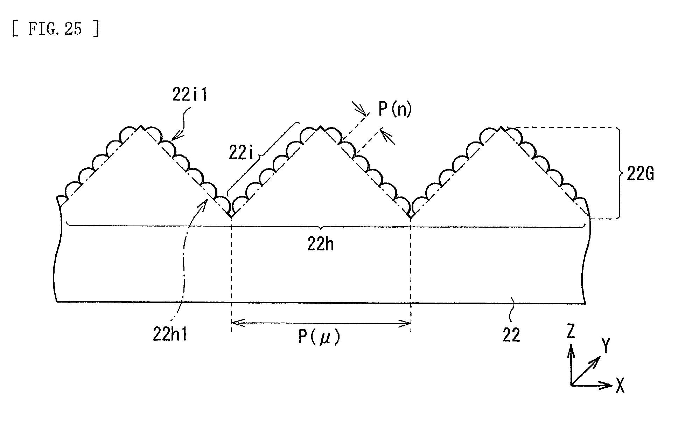

FIG. 25 illustrates a sectional structure of a transparent substrate of a photoelectric conversion device according to modification 4. The photoelectric conversion device according to this modification has a three-dimensional structure 22G including a fine concave-convex structure on one principal surface of the transparent substrate 22 as in the embodiment, but is different from the photoelectric conversion device in the embodiment in that the three-dimensional structure 22G includes a hybrid structure having a microstructure and a nanostructure as described below. In detail, the three-dimensional structure 22G includes a microstructure 22h (first concave-convex structure corresponding to the whole structure shown by a dot-dash line), and a nanostructure 22i (second concave-convex structure) provided on a surface of the microstructure 22h. In other words, the three-dimensional structure 22G includes the nanostructure 22i superimposed on the microstructure 22h. A light receiving element 23 is provided on the three-dimensional structure 22G of the transparent substrate 22, as in the embodiment, and at least a transparent electrode 24 of the light receiving element 23 has an concave-convex structure (a third concave-convex structure) in accordance with one or both of the microstructure 22h and the nanostructure 22i on a surface, on the side opposite to the transparent substrate 22, of the transparent electrode 24. This increases light absorptance of the light receiving element 23, and increases current density due to concentration of an electric field, leading to a further improvement in conversion efficiency (power generation efficiency) of the photoelectric conversion device.

The microstructure 22h includes a plurality of convex portions 22h1 that are two-dimensionally arranged at a pitch p($\mu$) of the order of micrometer on the surface of the transparent substrate 22. The pitch p($\mu$) is desirably more than 0.8 $\mu$m and less than 250 $\mu$m, which is equal to or larger than the visible wavelengths, , and the height thereof is set to an appropriate value depending on size of the pitch. If a pitch of the convex portions 22h1 is more than 250 $\mu$m, the thickness required for the transparent substrate 22 increases, resulting in loss of flexibility. A pitch of the convex portions 22h1 of less than 250 $\mu$m increases the flexibility, thus facilitating roll-to-roll production, and thus eliminating the need of so-called batch production. A pitch of 20 $\mu$m to 200 $\mu$m both inclusive further improves the productivity.

The so-called corner cube prism (CCP), for example, as shown in FIG. 19, may be used for the microstructure 22h, so that the microstructure 22h1 exhibits a multiple reflection property.

It is to be noted that the microstructure 22h is not limited to the case where the plurality of convex portions 22h1 are two-dimensionally arranged on the substrate surface and each convex portion 22h1 is a CCP, but may include one-dimensional prisms each having another shape, for example, prisms having other pyramidal shapes such as quadrangular-pyramidal shape and conical shape or prisms having columnar shape such as a polygonal columnar shape and cylindrical shape.

The nanostructure 22i includes a plurality of elongated protruding portions 22i 1 (second convex portions) at a pitch p(n) of the order of nanometer on the surface of the transparent substrate 22. The pitch p(n) is desirably equal to or less than the visible wavelengths, and more desirably more than 200 nm and equal to or less than 300 nm. In this embodiment, the plurality of elongated protruding portions 22i1 are regularly arranged at a pitch p(n) of 275 nm. The height H of each elongated protruding portion 22i1 is, for example, 30 nm to 100 $\mu$m both inclusive. The aspect ratio is desirably 0.2 to 2.0 both inclusive. This is because if the aspect ratio is more than 2.0, a light receiving element 11 is hard to be stacked on the transparent substrate 22. In contrast, if an aspect ratio is less than 0.2, a refractive index in a stacked direction steeply changes at an interface between the transparent substrate 22 and a transparent electrode 24 and in the vicinity of the interface, leading to a high total reflectivity at the interface. If the aspect ratio is 0.2 or more, the total reflectivity decreases, leading to an increase in a ratio of light that enters from the light-incident surface 21 A and is incident on the photoelectric conversion layer 25 through the transparent substrate 22 and the transparent electrode 24.

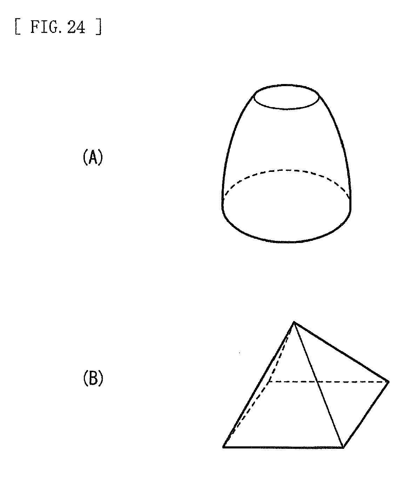

For the nanostructure 22i, the moth-eye structure described in the modification 2, and the three-dimensional structure shown in FIGs. 24(A) and 24(B) may be used in addition to the three-dimensional structure described in the embodiment.

It is to be noted that, to produce the photoelectric conversion device as described above, the microstructure 22h and the nanostructure 22i are produced on one principal surface of the transparent substrate 22, and then a light receiving element 23 is formed on the one principal surface of the transparent substrate 22. To form the light receiving element 23, an concave-convex structure in accordance with one or both of the microstructure 22h and the nanostructure 22i is formed on at least a surface, on the side opposite to the transparent substrate 22, of the transparent electrode 24. The photoelectric conversion layer 25 and the reflective electrode 26 are provided on the transparent electrode 24 formed in this way, resulting in formation of the light receiving element 23. This allows formation of a light receiving element having a high light absorptance and a large current density, which in turn enables manufacturing of a photoelectric conversion device having higher conversion efficiency (power generation efficiency).

[Modification 5]

A photoelectric conversion device according to this modification has an anti-reflection (AR) film (not illustrated) on its light-incident surface (the light-incident surface 21A shown in FIG. 1, the other major surface (back) of the transparent substrate 22) side. The reflective index of the anti-reflection film is less than 1%, preferably less than 0.1%, and more preferably less than 0.05%. Examples of such an anti-reflection film include a film having a moth-eye structure. For the moth-eye structure, a similar moth-eye structure to that in the modification 2 (the structure including bell-shaped convex portions that are two-dimensionally arranged) may be used, but other structures may be obviously used.

The anti-reflection film is provided on the light-incident surface side of the photoelectric conversion device as in the modification, thereby reflection of incident light is suppressed, and light absorptance of the light receiving element 23 increases, and therefore power generation efficiency may be more improved.

It is to be noted that not only such an anti-reflection film, but also other films, which suppress reflection and scattering of incident light and thus improves light absorptance of the light receiving element 23, for example, an anisotropic scattering film may be used.

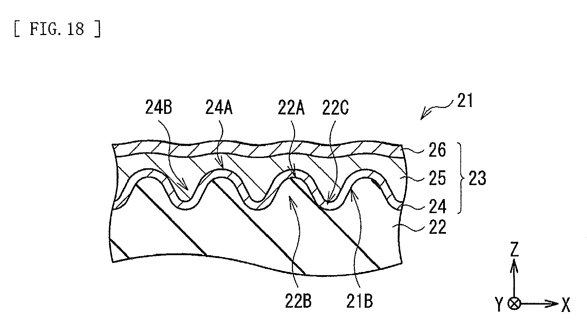

Although the invention has been described with the embodiment hereinbefore, the invention is not limited to the embodiment, and various modifications may be made. For example, although each surface, on the side opposite to the transparent substrate 22, of the photoelectric conversion layer 25 and the reflective electrode 26 has a wavy shape due to the convex portions 22B of the transparent substrate 22 in the embodiment, the surface may be, for example, substantially flat (namely, may have a gently wavy shape) as shown in the modification of FIG. 18.

In addition, although the modification 1 or 2, which includes the three-dimensional structure where the plurality of convex portions are arranged two dimensionally, has been described with the exemplary retroreflective structure including, as the three-dimensional structure, the triangular-pyramid-shaped CCPs, or the moth-eye structure including the bell-shaped convex portions, the shape of each convex portion is not limited to these. For example, as shown in FIG. 24(A), the moth-eye structure of the modification 2 may have a shape where the top of each convex portion is chamfered (a shape having a flat bell-like top). In addition, the retroreflective structure of the modification 1 may be a structure including two-dimensionally arranged prisms each having a pyramidal shape such as a quadrangular pyramid as shown in FIG. 24(B). In such a case, a structure need not necessarily have the retroreflective property as long as the structure causes multiple reflection.

Furthermore, although the embodiment and others have been described with the exemplary organic thin-film solar cell as the photoelectric conversion device of the invention, the invention may be applied to other types of solar cell devices, for example, a silicon-hybrid-type solar cell including an (amorphous or microcrystalline) silicon thin film, or an inorganic solar cell including a CdTe- or CIGS-based inorganic compound. The CIGS-based solar cell is preferably designed such that a reflective electrode as a first electrode, a photoelectric conversion layer, and a transparent electrode as a second electrode are stacked in this order on a surface of a transparent substrate, and light is incident from a transparent electrode side. In addition, the invention may be applied to, for example, a dye-sensitized solar cell other than the above described solar cells. In such a case, the resistance component of the dye-sensitized solar cell may be reduced.

In addition, the invention may be applied to an organic solar cell including fullerene ($C_{60}$). Such a solar cell includes a pin-junction-type organic thin-film solar cell where the fullerene ($C_{60}$) is used as an n-type organic semiconductor, zinc phthalocyanine (ZnPc) is used as a p-type organic semiconductor, and a nanostructure layer (i layer) including a mixture of $C_{60}$ and ZnPc is introduced into a pn junction interface formed with $C_{60}$ and ZnPc.

It is to be noted that the above-described embodiment, Examples, and modifications may be carried out in a combined manner. In addition, the transparent substrates, each having the predetermined concavity and convexity, for the photoelectric conversion device described in the embodiment, the Examples, and the modifications are intended to be included in the scope of the invention.

**Claims**

1.  A photoelectric conversion device comprising:

a substrate including, on a surface, a first three-dimensional structure where a plurality of convex portions are regularly arranged; and

a light receiving element being provided on the surface of the substrate, and including a first electrode, a photoelectric conversion layer, and a second electrode in this order of closeness to the substrate,

wherein at least the first electrode of the light receiving element has a second three-dimensional structure in accordance with the first three-dimensional structure on a surface on a side opposite to the substrate.

2. The photoelectric conversion device according to claim 1, wherein,
in the first three-dimensional structure,
the plurality of convex portions are each provided to extend along one direction, and are disposed in parallel along a direction orthogonal to the extending direction.

3. The photoelectric conversion device according to claim 2, wherein a pitch of the plurality of convex portions is of order of nanometer.

4. The photoelectric conversion device according to claim 1, wherein an aspect ratio of each of the plurality of convex portions is 0.2 to 2.0 both inclusive.

5. The photoelectric conversion device according to claim 1, wherein a pitch of the plurality of convex portions is equal to or smaller than wavelength order of visible light.

6. The photoelectric conversion device according to claim 5, wherein the pitch of the plurality of convex portions is more than 200 nanometers and equal to or less than 300 nanometers.

7. The photoelectric conversion device according to claim 1, wherein,
in the first three-dimensional structure,
the plurality of convex portions each have a rounded top.

8. The photoelectric conversion device according to any one of claims 1 to 7, wherein,
in the first three-dimensional structure,
the plurality of convex portions are two-dimensionally arranged on the surface of the substrate.

9. The photoelectric conversion device according to claim 8, wherein
the first three-dimensional structure has a moth-eye structure, and
the aspect ratio of each of the convex portions is 0.6 to 1.2 both inclusive.

10. The photoelectric conversion device according to claim 7, wherein the first three-dimensional structure has a multiple reflection structure.

11. The photoelectric conversion device according to claim 10, wherein
a pitch of the plurality of convex portions is more than 0.8 micrometers and less than 250 micrometers in the multiple reflection structure.

12. The photoelectric conversion device according to claim 1, wherein
one of the first and second electrodes and the substrate are composed of a material transparent to light received by the photoelectric conversion layer.

13. A photoelectric conversion device comprising:

a substrate including a first concave-convex structure, and a second concave-convex structure on a principal surface, the first concave-convex structure including a plurality of first convex portions, the second concave-convex structure being provided on a surface of the first concave-convex structure and including a plurality of second convex portions; and

a light receiving element being provided on one principal surface side of the substrate, and including a first electrode, a photoelectric conversion layer, and a second electrode in this order of closeness to the substrate, wherein at least the first electrode of the light receiving element includes a third concave-convex structure in accordance with one or both of the first and second concave-convex structures on a surface on a side opposite to the substrate.

**14.** The photoelectric conversion device according to claim 1 or claim 13, wherein an anti-reflection film is provided on a light-incident side of the photoelectric conversion device.

**15.** A method of manufacturing a photoelectric conversion device comprising:

forming, on a surface of a substrate, a first three-dimensional structure in which a plurality of convex portions are regularly arranged; and

forming a light receiving element including a first electrode, a photoelectric conversion layer, and a second electrode in this order on the surface of the substrate on which the first three-dimensional structure is formed, wherein

the forming of the light receiving element includes forming a second three-dimensional structure in accordance with the first three-dimensional structure on at least a surface, on a side opposite to the substrate, of the first electrode.

**16.** The method of manufacturing a photoelectric conversion device according to claim 15, wherein in the forming of the first three-dimensional structure on the surface of the substrate, the first three-dimensional structure is formed on the surface of the substrate through transfer using a die having a concave-convex pattern corresponding to the first three-dimensional structure.

**17.** The method of manufacturing a photoelectric conversion device according to claim 15, wherein the die has a roll-like or plate-like shape.

**18.** The method of manufacturing a photoelectric conversion device according to claim 16 or claim 17, wherein the concave-convex pattern of the die is formed by bite-cutting.

**19.** The method of manufacturing a photoelectric conversion device according to claim 16 or claim 17, wherein the concave-convex pattern of the die is formed by photolithography.

**20.** The method of manufacturing a photoelectric conversion device according to claim 16 or claim 17, wherein the concave-convex pattern of the die is formed with a femtosecond laser.

**Amended claims under Art. 19.1 PCT**

**1.** (amended) A photoelectric conversion device comprising:

a substrate including, on a surface, a first three-dimensional structure where a plurality of convex portions having a pitch of order of nanometer are two-dimensionally arranged; and

a light receiving element being provided on the surface of the substrate, and including a first electrode, a photoelectric conversion layer, and a second electrode in this order of closeness to the substrate,

wherein at least the first electrode of the light receiving element has a second three-dimensional structure in accordance with the first three-dimensional structure on a surface on a side opposite to the substrate, and

the first three-dimensional structure has a moth-eye structure.

**2.** The photoelectric conversion device according to claim 1, wherein, in the first three-dimensional structure, the plurality of convex portions are each provided to extend along one direction, and are disposed in parallel along a direction orthogonal to the extending direction.

**3.** (cancelled)

**4.** The photoelectric conversion device according to claim 1, wherein an aspect ratio of each of the plurality of convex portions is 0.2 to 2.0 both inclusive.

**5.** The photoelectric conversion device according to claim 1, wherein a pitch of the plurality of convex portions is equal to or smaller than wavelength order of visible light.

**6.** The photoelectric conversion device according to claim 5, wherein the pitch of the plurality of convex portions is more than 200 nanometers and equal to or less than 300 nanometers.

**7.** The photoelectric conversion device according to claim 1, wherein,
in the first three-dimensional structure,
the plurality of convex portions each have a rounded top.

**8.** (cancelled)

**9.** (amended) The photoelectric conversion device according to claim 1, wherein
an aspect ratio of each of the convex portions of the moth-eye structure is 0.6 to 1.2 both inclusive.

**10.** (cancelled)

**11.** (cancelled)

**12.** The photoelectric conversion device according to claim 1, wherein
one of the first and second electrodes and the substrate are composed of a material transparent to light received
by the photoelectric conversion layer.

**13.** (cancelled)

**14.** (amended) The photoelectric conversion device according to claim 1, wherein an anti-reflection film is provided
on a light-incident side of the photoelectric conversion device.

**15.** (amended) A method of manufacturing a photoelectric conversion device comprising:

forming, on a surface of a substrate, a first three-dimensional structure in which a plurality of convex portions
having a pitch of order of nanometer are two-dimensionally arranged; and
forming a light receiving element including a first electrode, a photoelectric conversion layer, and a second
electrode in this order on the surface of the substrate on which the first three-dimensional structure is formed,
wherein
the forming of the light receiving element includes forming a second three-dimensional structure in accordance
with the first three-dimensional structure on at least a surface, on a side opposite to the substrate, of the first
electrode, and
the first three-dimensional structure has a moth-eye structure.

**16.** The method of manufacturing a photoelectric conversion device according to claim 15, wherein
in the forming of the first three-dimensional structure on the surface of the substrate,
the first three-dimensional structure is formed on the surface of the substrate through transfer using a die having a
concave-convex pattern corresponding to the first three-dimensional structure.

**17.** The method of manufacturing a photoelectric conversion device according to claim 15, wherein the die has a
roll-like or plate-like shape.

**18.** (amended) The method of manufacturing a photoelectric conversion device according to claim 16, wherein the
concave-convex pattern of the die is formed by bite-cutting.

**19.** (amended) The method of manufacturing a photoelectric conversion device according to claim 16, wherein the
concave-convex pattern of the die is formed by photolithography.

**20.** (amended) The method of manufacturing a photoelectric conversion device according to claim 16, wherein the
concave-convex pattern of the die is formed with a femtosecond laser.

**21.** (added) The method of manufacturing a photoelectric conversion device according to claim 15, wherein an
aspect ratio of each of the convex portions of the moth-eye structure is 0.6 to 1.2 both inclusive.

[ FIG. 1 ]

(A)

(B)

[ FIG. 2 ]

(A)                                              22e

(B)                                              22e
                                                 22f

(UV)

(C)                                              22e
                                                 22f
                                                 30

(D)                                              22e  ⎤
                                                      ⎬ 22
                                                 22A ⎦
                                                 22B

                                                 30

[ FIG. 3 ]

[ FIG. 4 ]

(UV)
↓    ↓    ↓    ↓

22e          22f

30B

[ FIG. 5 ]

INTENSITY

y

x

Ly

Lx

[ FIG. 6 ]

(A)

400

420

410

430

30A

330

POLARIZATION DIRECTION

(B)

400

420

410

430

30B

440

POLARIZATION DIRECTION

[ FIG. 7 ]

(A)

(B)

[ FIG. 8 ]

[ FIG. 9 ]

[ FIG. 10 ]

## FLAT PLATE

~100

(A)

| AlSiCu |
| LiF |
| BCP |
| C60 |
| CuPc |
| IZO |
| Glass |

## THREE-DIMENSIONAL STRUCTURE (PITCH OF 150nm)

~10

(B)

| AlSiCu |
| LiF |
| BCP |
| C60 |
| CuPc |
| IZO |
| SiO2 |

150nm

[ FIG. 11 ]

## MEASUREMENT RESULT OF IMPEDANCE IN THE CASE WITH FLAT PLATE

(A)

Z' (Ω)

## MEASUREMENT RESULT OF IMPEDANCE IN THREE-DIMENSIONAL STRUCTURE (PITCH OF 150nm)

(B)

Z' (Ω)

[ FIG. 12 ]

[ FIG. 13 ]

[ FIG. 14 ]

CURRENT-VOLTAGE CHARACTERISTICS IN FLAT PLATE STRUCTURE

(A)

(WITHOUT LIGHT IRRADIATION)

(B)

(WITH LIGHT IRRADIATION)

n=2.031
Jo=0.000063
Rs=0.291

n=2.031
Jo=0.000063
Rs=0.291
m=2.0
I/Csh=0.0579
Jp=6.06

[ FIG. 15 ]

EP 2 515 344 A1

## CURRENT-VOLTAGE CHARACTERISTICS IN THREE-DIMENSIONAL STRUCTURE (PITCH OF150nm)

(A)

(WITHOUT LIGHT IRRADIATION)

n=3.451
$J_o$=0.006
$R_s$=0.0428

(B)

(WITH LIGHT IRRADIATION)

n=3.451
$J_o$=0.006
$R_s$=0.0428
m=2.0
$I/C_{sh}$=0.0957
$J_p$=3.94

[ FIG. 16 ]

THREE-DIMENSIONAL
STRUCTURE (275nm)　　4.7

FLAT PLATE　　1.0

0　1　2　3　4　5

CONVERSION EFFICIENCY (RATIO TO FLAT PLATE) [-]

[ FIG. 17 ]

26
(100nm)

25
(130nm)

24
(100nm)

22

200nm

[ FIG. 18 ]

[ FIG. 19 ]

(A)

P1    S1    10b1    P2

22

P4

S3                              S2

P3

Y
Z⊙→X

S1

P4

P1

10b1

P2

(B)

S3

S2

P3

[ FIG. 20 ]

[ FIG. 21 ]

[ FIG. 22 ]

CORRELATION OF CHANGE IN ABSORBED AMOUNT

[ FIG. 23 ]

32A

32B

(A)

32

32B

(B)

[ FIG. 24 ]

(A)

(B)

[ FIG. 25 ]

| INTERNATIONAL SEARCH REPORT | International application No. |
|---|---|
| | PCT/JP2010/072019 |

A. CLASSIFICATION OF SUBJECT MATTER
*H01L31/04*(2006.01)i, *H01L51/42*(2006.01)i

According to International Patent Classification (IPC) or to both national classification and IPC

B. FIELDS SEARCHED

Minimum documentation searched (classification system followed by classification symbols)
H01L31/04, H01L51/42

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 59-152672 A (Semiconductor Energy Laboratory Co., Ltd.), 31 August 1984 (31.08.1984), page 4, lower left column; examples 1 to 2; fig. 3 to 4 (Family: none) | 1-12,14-17, 19 |
| X | JP 2003-298085 A (TDK Corp.), 17 October 2003 (17.10.2003), paragraphs [0023] to [0024], [0039] to [0041], [0045] (Family: none) | 1-2,4,7-12, 15-20 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 February, 2011 (10.02.11) | 22 February, 2011 (22.02.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/072019

C (Continuation).    DOCUMENTS CONSIDERED TO BE RELEVANT

| Category* | Citation of document, with indication, where appropriate, of the relevant passages | Relevant to claim No. |
|---|---|---|
| X | JP 60-201668 A (Director General, Agency of Industrial Science and Technology), 12 October 1985 (12.10.1985), page 2, upper right column to page 4, upper left column; fig. 1 (Family: none) | 1-2,4,7, 10-11,15-17 |
| X | JP 10-70294 A (Sharp Corp.), 10 March 1998 (10.03.1998), fig. 3 (Family: none) | 13 |
| A | JP 2008-153570 A (Sharp Corp.), 03 July 2008 (03.07.2008), paragraph [0012] (Family: none) | 9 |

## INTERNATIONAL SEARCH REPORT

| International application No. |
| --- |
| PCT/JP2010/072019 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:
    The matter common to claims 1 – 20 is disclosed in the document 1 (JP 59-152672 A, page 4, lower left column, examples 1 – 2, fig. 3 – 4), the document 2 (JP 2003-298085 A, paragraphs [0023] – [0024], [0039] – [0041], [0045]), and the document 3 (JP 60-201668 A, page 2, upper right column – page 4, upper left column, fig. 1), respectively.
                                              (continued to extra sheet)

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (July 2009)

| **INTERNATIONAL SEARCH REPORT** | International application No. |
|---|---|
| | PCT/JP2010/072019 |

Continuation of Box No.III of continuation of first sheet(2)

Therefore, claims 1- 12, 14 - 20 and claim 13 pertain to the inventions different from each other. Furthermore, claims 1 - 3 have no special technical feature within the meaning of PCT Rule 13.2, second sentence in the light of the document 1.

As a result of judging special technical features at the time of issuance of the order for payment of additional fees, also the inventions in claims 4 - 12, 14 - 20 cannot be considered to have special technical features. If the inventions in claims 4 - 12, 14 - 20 are classified into invention 1, it is considered that the following "two" inventions are involved in the present application.

(Invention 1) claims 1 - 12, 14 - 20

(Invention 2) claim 13
(Substrate having a second unevenness structure on the surface of a first unevenness structure)

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009278145 A